# EUROPEAN PATENT APPLICATION

(11) **EP 4 561 298 A1**
(43) Date of publication of application: **28.05.2025**
(21) Application number: 24194579.9
(22) Date of filing: 14.08.2024
(51) Int. Cl.: H10D 86/40

(54) **DISPLAY APPARATUS**

(30) Priority: 22.11.2023 KR 20230163697
(71) Applicant: Samsung Display Co., Ltd., Gyeonggi-do 17113 (KR)
(72) Inventor: Park, Jongryuk, 17113 Giheung-gu, Yongin-si (KR); Kim, Hyunyoung, 17113 Giheung-gu, Yongin-si (KR)
(74) Representative: Dr. Weitzel & Partner

(57) **Abstract**

A display apparatus includes a substrate including a display area and a peripheral area outside the display area. A first active pattern is arranged in the display area. A first gate electrode is disposed of the first active pattern. A second active pattern is disposed on the first gate electrode. A second gate electrode is disposed on the second active pattern. A dummy pattern is arranged in the peripheral area. The dummy pattern extends in a first direction. The dummy pattern is disposed on a same layer as the second gate electrode.

## Description

### 1. Technical Field

The present invention relates to a display apparatus.

### 2. Discussion of Related Art

Display devices generate images to a view which contain various pieces of electrical signal information. As the display industry has developed, display apparatuses having increased thinness, weight reduction, and lower power consumption are being developed. Among display apparatuses, organic light-emitting display apparatuses in particular have advantages of a wide viewing angle, excellent contrast, and fast response speed, thereby gaining attention as next-generation display apparatuses.

An organic light-emitting display apparatus includes a thin-film transistor (TFT) and a capacitor, or the like as a driving circuit. The TFT may include an active layer including a channel area, a source area, and a drain area, and a gate electrode electrically insulated from the active layer by a gate insulating layer. In general, the active layer of the TFT may be formed of a silicon semiconductor material such as amorphous silicon or polysilicon. Alternatively, the active layer of the TFT may be formed of an oxide semiconductor material.

### SUMMARY

The present invention is defined by the features of claim 1. The dependent claims describe preferred embodiments.

One or more embodiments include a display apparatus with increased device characteristics and reduced occurrence of defects of the thin-film transistor. However, the scope of embodiments of the present invention is not limited to these aspects.

Additional aspects will be set forth in part in the description which follows and, in part, will be apparent from the description, or may be learned by practice of the described, non-limiting embodiments of the invention.

According to the present invention, a display apparatus includes a substrate including a display area and a peripheral area outside the display area. A first active pattern is arranged in the display area. A first gate electrode is disposed of the first active pattern. A second active pattern is disposed on the first gate electrode. A second gate electrode is disposed on the second active pattern. A dummy pattern is arranged in the peripheral area. The dummy pattern extends in a first direction. The dummy pattern is disposed on a same layer as the second gate electrode.

In an embodiment, the second gate electrode may extend in the first direction, the second active pattern may extend in a second direction crossing the first direction, and the second active pattern may at least partially overlap the second gate electrode in a plan view.

In an embodiment, the display apparatus may further include a gate line extending in the first direction. The second gate electrode is electrically connected to the gate line through a contact hole penetrating an insulating layer between the second gate electrode and the gate line.

In an embodiment, the gate line may be disposed between the first gate electrode and the second active pattern.

In an embodiment, the display apparatus may further include a first sub-pixel including a first sub-pixel circuit and a second sub-pixel including a second sub-pixel circuit, which are arranged in the display area to be adjacent to each other. The first sub-pixel circuit may include the first active pattern, the first gate electrode, the second active pattern, and the second gate electrode, and the first sub-pixel circuit and the second sub-pixel circuit may have symmetrical shapes to each other based on a virtual line between the first sub-pixel circuit and the second sub-pixel circuit.

In an embodiment, the second sub-pixel circuit may include a third active pattern on the substrate, a third gate electrode disposed on the third active pattern, a fourth active pattern disposed on the third gate electrode, and a fourth gate electrode disposed on the fourth active pattern. The second gate electrode and the fourth gate electrode are integral to each other and comprise one gate pattern.

In an embodiment, in a plan view, the gate pattern may have a shape isolated from all other patterns disposed on a same layer as the gate pattern.

In an embodiment, each of the first active pattern and the third active pattern may include a silicon semiconductor material, and each of the second active pattern and the fourth active pattern may include an oxide semiconductor material.

In an embodiment, the display apparatus may further include a first peripheral voltage line arranged in the peripheral area and extending in the first direction, and a second peripheral voltage line arranged outside the first peripheral voltage line and extending in the first direction.

In an embodiment, the dummy pattern may be electrically connected to the first peripheral voltage line.

In an embodiment, the display apparatus may further include extension portions extending from the second peripheral voltage line in a second direction perpendicular to the first direction.

In an embodiment, the dummy pattern may be electrically insulated from the second peripheral voltage line and the extension portions.

In an embodiment, in a plan view, the dummy pattern may overlap the extension portions in a plan view.

In an embodiment, the dummy pattern may include a first dummy pattern extending in the first direction, a second dummy pattern spaced apart from the first dummy pattern and extending in the first direction, and a connection portion connecting the first dummy pattern to the second dummy pattern. The first dummy pattern, the second dummy pattern, and the connection portion are integral to each other.

In an embodiment, in a plan view, the first dummy pattern may be arranged between the display area and the first peripheral voltage line.

In an embodiment, in a plan view, the second dummy pattern may overlap the first peripheral voltage line.

In an embodiment, in a plan view, the second dummy pattern may overlap at least some of the extension portions.

In an embodiment, in a plan view, the dummy pattern may be spaced apart from the extension portions and does not overlap the extension portions.

In an embodiment, the dummy pattern may include a first dummy pattern extending in the first direction, second dummy patterns spaced apart from each other in the first direction, and connection portions respectively connecting the second dummy patterns to the first dummy pattern. The first dummy pattern, the second dummy patterns, and the connection portions may be integral to each other.

In an embodiment, in a plan view, each of the second dummy patterns may be arranged between two adjacent extension portions.

### BRIEF DESCRIPTION OF THE DRAWINGS

The above and other aspects, features, and advantages of certain non-limiting embodiments of the present invention will be more apparent from the following description taken in conjunction with the accompanying drawings, in which:
FIG. 1 is a schematic plan view illustrating a portion of a display apparatus according to an embodiment of the present invention;
FIG. 2 is a schematic side view illustrating the display apparatus of FIG. 1 according to an embodiment of the present invention;
FIG. 3 is a schematic plan view illustrating a display panel according to an embodiment of the present invention;
FIGS. 4 and 5 are schematic enlarged plan views of portion A of FIG. 3 according to embodiments of the present invention;
FIG. 6 is an equivalent circuit diagram of a sub-pixel included in a display apparatus according to an embodiment of the present invention;
FIG. 7 is a schematic plan view illustrating a structure of a sub-pixel circuit according to an embodiment of the present invention;
FIGS. 8A to 8H are plan views illustrating components configuring the sub-pixel circuit of FIG. 7 for each layer according to embodiments of the present invention;
FIG. 9 is a schematic cross-sectional view illustrating a portion of a sub-pixel circuit according to an embodiment of the present invention;
FIG. 10 is a schematic plan view illustrating a portion of a sub-pixel circuit according to an embodiment of the present invention;
FIG. 11 is a schematic cross-sectional view of the sub-pixel circuit of FIG. 10, taken along a line B-B' according to an embodiment of the present invention;
FIG. 12 is a cross-sectional view illustrating a modified example of FIG. 11 according to an embodiment of the present invention;
FIG. 13 is a schematic enlarged plan view of portion D of FIG. 3 according to an embodiment of the present invention;
FIGS. 14A to 14E are plan views illustrating a structure of FIG. 13 for each layer according to embodiments of the present invention;
FIG. 15 is a schematic cross-sectional view of the display panel of FIG. 13, taken along a line I-I' according to an embodiment of the present invention;
FIG. 16 is a plan view illustrating a modified example of FIG. 13 according to an embodiment of the present invention;
FIG. 17 is a plan view illustrating some layers of FIG. 16 according to an embodiment of the present invention; and
FIG. 18 is a schematic cross-sectional view of the display panel of FIG. 16, taken along a line II-II' according to an embodiment of the present invention.

### DETAILED DESCRIPTION OF EMBODIMENTS

Reference will now be made in detail to embodiments, examples of which are illustrated in the accompanying drawings, wherein like reference numerals refer to like elements throughout. In this regard, the described embodiments may have different forms and embodiments of the present invention should not be construed as being limited to the descriptions set forth herein. Accordingly, embodiments are merely described below, by referring to the figures, to explain aspects of the present description. As used herein, the term "and/or" includes any and all combinations of one or more of the associated listed items. Throughout the present disclosure, the expression "at least one of a, b or c" indicates only a, only b, only c, both a and b, both a and c, both b and c, all of a, b, and c, or variations thereof.

As the present invention allows for various changes and numerous embodiments, particular embodiments will be illustrated in the drawings and described in detail in the written description. Effects and features of the present invention and methods of achieving the same will be apparent with reference to embodiments and drawings described below in detail. The present invention may, however, be embodied in many different forms and should not be construed as being limited to the described embodiments set forth herein.

The present invention will now be described more fully with reference to the accompanying drawings, in which embodiments are shown. Like reference numerals in the drawings denote like elements, and thus their description will not be repeated.

In the following embodiments, while such terms as "first," "second," etc., may be used to describe various elements, such elements must not be limited to the above terms.

In the following embodiments, an expression used in the singular encompasses the expression of the plural, unless it has a clearly different meaning in the context.

In the following embodiments, it is to be understood that the terms such as "including," "having," and "comprising" are intended to indicate the existence of the features, or elements disclosed in the specification, and are not intended to preclude the possibility that one or more other features or elements may exist or may be added.

It will be understood that when a layer, region, or element is referred to as being formed on another layer, region, or element, it can be directly or indirectly formed on the other layer, region, or element. That is, for example, intervening layers, regions, or elements may be present.

Sizes of elements in the drawings may be exaggerated for convenience of explanation. In other words, since sizes and thicknesses of components in the drawings may be arbitrarily illustrated for convenience of explanation, embodiments of the present invention are not necessarily limited thereto.

When a certain embodiment may be implemented differently, a specific process order may be performed differently from the described order. For example, two consecutively described processes may be performed substantially at the same time or performed in an order opposite to the described order.

In the present specification, "A and/or B" may include "A," "B," or "A and B." In addition, "at least one of A and B" may include "A," "B," or "A and B."

It will be understood that when a layer, region, or component is referred to as being connected to another layer, region, or component, it can be directly or indirectly connected to the other layer, region, or component. For example, intervening layers, regions, or components may be present. For example, it will be understood that when a layer, region, or component is referred to as being electrically connected to another layer, region, or component, it can be directly or indirectly electrically connected to the other layer, region, or component. That is, for example, intervening layers, regions, or components may be present. When a layer, region, or component is referred to as being directly connected to another layer, region, or component either physically or electrically, no intervening elements may be present.

The x-axis, the y-axis and the z-axis are not limited to three axes of the rectangular coordinate system, and may be interpreted in a broader sense. For example, in an embodiment the x-axis, the y-axis, and the z-axis may be perpendicular to one another, or may represent different directions that cross each other but are not perpendicular to one another.

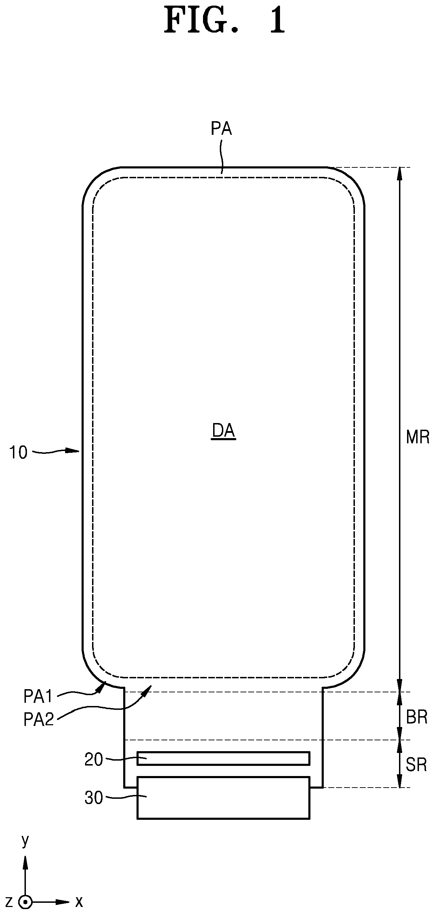

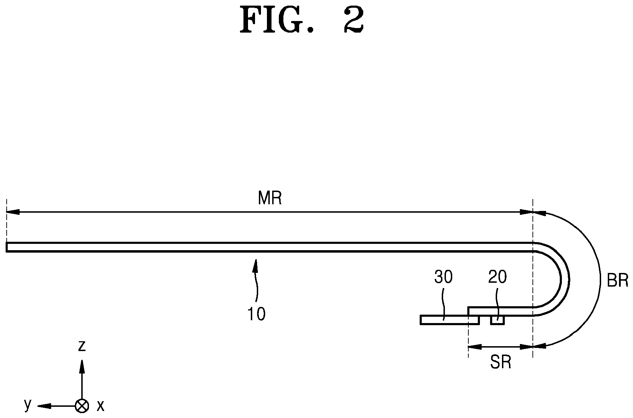

FIG. 1 is a schematic plan view illustrating a portion of a display apparatus according to an embodiment, and FIG. 2 is a schematic side view illustrating the display apparatus of FIG. 1. A portion of the display apparatus according to an embodiment is bent as shown in FIG. 2, but the display apparatus in FIG. 1 is shown as not bent for convenience.

Referring to FIGS. 1 and 2, the display apparatus includes a display panel 10. The display apparatus may be any type of electronic device that includes the display panel 10. For example, in an embodiment the display apparatus may be various products such as a smart phone, a tablet, a laptop, a television, a billboard, or the like.

The display panel 10 includes a display area DA and a peripheral area PA outside the display area DA (e.g., in the x and y directions). The display area DA is a portion of the display panel 10 that displays an image. A plurality of sub-pixels may be arranged in the display area DA. The display area DA may have various shapes, for example, a circular shape, an oval shape, a polygonal shape, a shape of a particular figure, or the like. In FIG. 1, the display area DA is shown to have a substantially rectangular shape with rounded corners. However, embodiments of the present invention are not necessarily limited thereto.

The peripheral area PA may be arranged outside the display area DA. In an embodiment, the peripheral area PA may include a first peripheral area PA1 arranged to surround at least a portion of the display area DA and a second peripheral area PA2 extending to one side (e.g., a -y direction) of the display area DA. In an embodiment, a width of the second peripheral area PA2 in one direction (e.g., an x direction) may be less than a width of the display area DA. Through this structure, at least a portion of the second peripheral area PA2 may be easily bent.

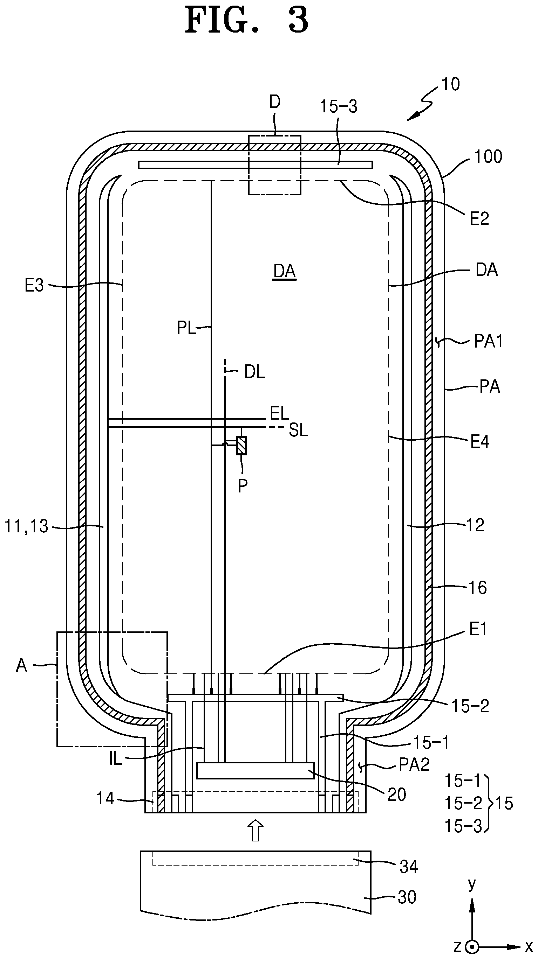

In an embodiment, since the display panel 10 includes a substrate 100 (refer to FIG. 3), the substrate 100 may have the display area DA and the peripheral area PA as described above. Hereinafter, for convenience, the substrate 100 is described as having the display area DA and the peripheral area PA.

The display panel 10 may also be seen to have a main area MR, a bending area BR outside the main area MR (e.g., in the -y direction), and a sub-area SR positioned on the opposite side of the main area MR around the bending area BR. As shown in FIG. 2, in the bending area BR, the display panel 10 may be bent, and at least a portion of the sub-area SR may overlap the main area MR when viewed from a z direction. However, embodiments of the present invention are not necessarily limited to a bent display apparatus and may also applied to a display apparatus that is not bent. The sub-area SR may be a non-display area, as will be described below. The display panel 10 is bent at the bending area BR, so that a non-display area may not be viewed or a visible area thereof may be reduced when viewing the display apparatus from a front surface (in a -z direction).

A data pad unit 20 may be arranged in the sub-area SR of the display panel 10. In an embodiment, the data pad unit 20 may include an integrated circuit (e.g., a driving chip) that drives the display panel 10. The integrated circuit may be a data driving integrated circuit that generates data signals. However, embodiments of the present invention are not necessarily limited thereto.

The data pad unit 20 may be mounted in the sub-area SR of the display panel 10. Although the data pad unit 20 is mounted on the same surface as a display surface of the display area DA, as described above, in an embodiment the data pad unit 20 may be positioned over a rear surface of the main area MR as the display panel 10 is bent at the bending area BR. In an embodiment, the data pad unit 20 may include a plurality of pads.

A printed circuit board 30 or the like may be attached to an end portion of the sub-area SR of the display panel 10. The printed circuit board 30 may be electrically connected to the data pad unit 20 or the like through the plurality of pads.

Hereinafter, according to an embodiment, an organic light-emitting display apparatus is described as an example of the display apparatus. However, embodiments of the present invention are not necessarily limited thereto and the display apparatus may be various different types. For example, in an embodiment, the display apparatus may be an inorganic light-emitting display apparatus, an inorganic electroluminescence display apparatus, or a quantum dot light-emitting display apparatus. For example, an emission layer of a display element included in the display apparatus may include an organic material, an inorganic material, a quantum dot, an organic material and a quantum dot, or an inorganic material and a quantum dot.

FIG. 3 is a schematic plan view illustrating a display panel according to an embodiment.

Referring to FIG. 3, the display panel 10 includes the substrate 100. Various components forming the display panel 10 are arranged on the substrate 100. In an embodiment, the substrate 100 may include glass, metal, or polymer resin. As described above, when the display panel 10 is bent at the bending area BR, the substrate 100 should be flexible or bendable. For example, in an embodiment the substrate 100 may include a polymer resin such as polyethersulfone, polyacrylate, polyetherimide, polyethylene naphthalate, polyethylene terephthalate, polyphenylene sulfide, polyarylate, polyimide, polycarbonate, or cellulose acetate propionate. In an embodiment, the substrate 100 may have a multi-layered structure including two layers each including the polymer resin and a barrier layer including an inorganic material (e.g., silicon oxide, silicon nitride, silicon oxynitride, or the like) arranged between the two layers, and various modifications may be made.

A plurality of sub-pixels P are arranged in the display area DA. Each of the plurality of sub-pixels P may be implemented by a display element such as an organic light-emitting diode (OLED). In an embodiment, the sub-pixel P may emit, for example, red, green, blue, or white light. However, embodiments of the present invention are not necessarily limited thereto and the plurality of sub-pixels P may emit various different colors.

The sub-pixel P may be electrically connected to outer circuits arranged in the peripheral area PA. For example, in an embodiment as shown in FIG. 3, a first scan driving circuit 11, a second scan driving circuit 12, an emission control driving circuit 13, a terminal 14, a first power supply line 15, and a second power supply line 16 may be arranged in the peripheral area PA.

The first scan driving circuit 11 may provide a scan signal to the sub-pixel P through a scan line SL. In an embodiment, the second scan driving circuit 12 may be arranged in parallel with the first scan driving circuit 11 with the display area DA therebetween (e.g., in the x direction). Some of the sub-pixels P arranged in the display area DA may be electrically connected to the first scan driving circuit 11, and the remaining sub-pixels P may be connected to the second scan driving circuit 12. However, embodiments of the present invention are not necessarily limited thereto and the number of scan driving circuits may vary. For example, in an embodiment, the second scan driving circuit 12 may be omitted.

In an embodiment, the emission control driving circuit 13 may be arranged on a side of the first scan driving circuit 11 and provide an emission control signal to the sub-pixel P through an emission control line EL. Although an embodiment in FIG. 3 has the emission control driving circuit 13 is arranged only on one side of the display area DA, the emission control driving circuit 13 may also be arranged on both sides of the display area DA, similarly to the first scan driving circuit 11 and the second scan driving circuit 12.

In an embodiment, the terminal 14 may be arranged in the second peripheral area PA2 of the substrate 100. In an embodiment, the terminal 14 may be exposed by not being covered by an insulating layer and may be electrically connected to the printed circuit board 30. A terminal 34 of the printed circuit board 30 may be electrically connected to the terminal 14 of the display panel 10.

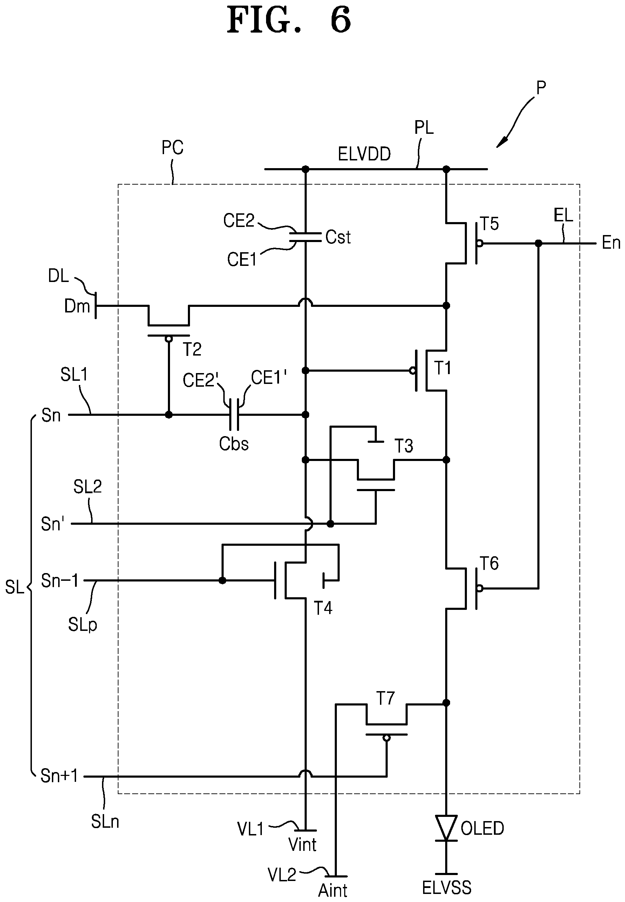

The printed circuit board 30 transmits a signal or power of a controller to the display panel 10. In an embodiment, a control signal generated by the controller may be transmitted to each of the first scan driving circuit 11, the second scan driving circuit 12, and the emission control driving circuit 13 through the printed circuit board 30. In addition, the controller may respectively provide a first power voltage ELVDD (refer to FIG. 6) and a second power voltage ELVSS (refer to FIG. 6) to the first power supply line 15 and the second power supply line 16. The first power voltage ELVDD (e.g., a driving voltage) may be provided to each sub-pixel P through a driving voltage line PL connected to the first power supply line 15, and the second power voltage ELVSS (e.g., a common voltage) may be provided to an opposite electrode of the sub-pixel P connected to the second power supply line 16. In addition, the controller may generate a data signal, and the generated data signal may be transmitted to an input line IL through the data pad unit 20 and to the sub-pixel P through a data line DL connected to the input line IL.

In an embodiment, the first power supply line 15 may include a first-1 power supply line 15-1, a first-2 power supply line 15-2, and a first-3 power supply line 15-3. In an embodiment, the first-1 power supply line 15-1 may extend in a second direction (e.g., a y direction), and the first-2 power supply line 15-2 and the first-3 power supply line 15-3 may extend in a first direction (e.g., an x direction). For example, the first-3 power supply line 15-3 may extend along a second edge E2 at an upper side (e.g., in the y direction) of the display area DA. In an embodiment, the first-1 power supply line 15-1, the first-2 power supply line 15-2, and the first-3 power supply line 15-3 may be integrally provided (e.g., may be integral with each other). For example, in an embodiment the first power supply line 15 may have a 'Π' shape as an integral body. However, embodiments of the present invention are not necessarily limited thereto.

In an embodiment, the second power supply line 16 may have a loop shape with one side open to partially surround the display area DA. For example, the second power supply line 16 may extend along the second edge E2, a third edge E3, and a fourth edge E4 of the display area DA. In an embodiment, the second power supply line 16 may be arranged outside the first power supply line 15.

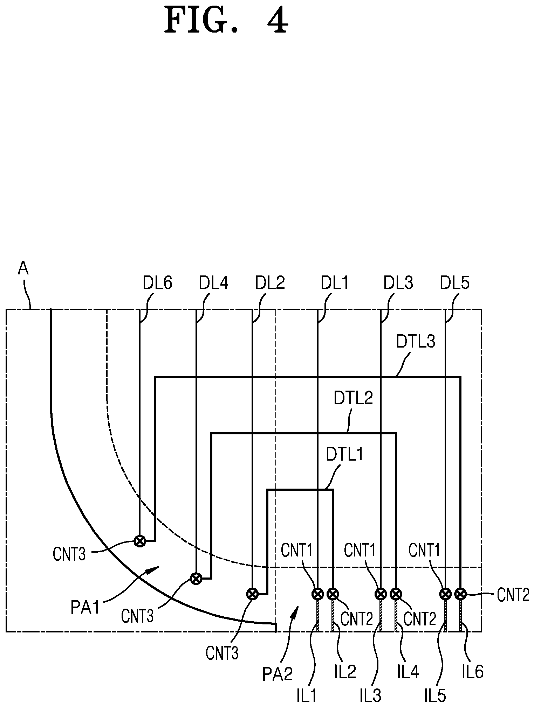

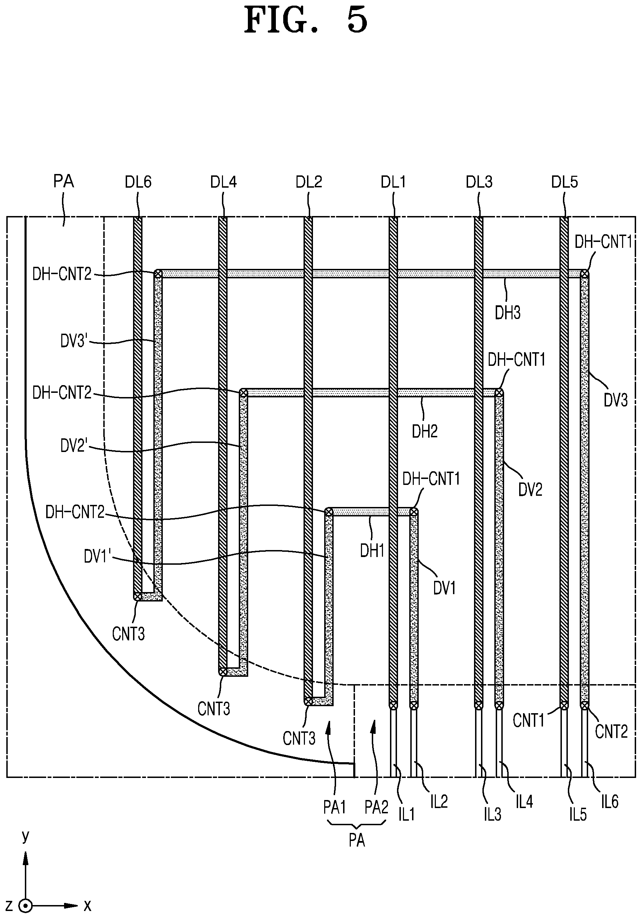

FIGS. 4 and 5 are schematic enlarged plan views of portion A of FIG. 3.

Referring to FIG. 4, various signals may be applied to the display area DA. For example, a data signal for adjusting the brightness of each sub-pixel or the like may be applied to the display area DA, and to this end, as shown in FIG. 4, first to sixth data lines DL1 to DL6 that are substantially parallel to each other may be disposed on an upper portion of the substrate 100 within the display area DA. In an embodiment, in addition to the first to sixth data lines DL1 to DL6, various lines such as power lines, scan lines, or the like may also be positioned inside and outside the display area DA.

In an embodiment, input lines IL, such as first to sixth input lines IL1 to IL6 each connected to (e.g., directly connected thereto) the data pad unit 20 and receiving a data signal may be arranged in the peripheral area PA, such as the second peripheral area PA2. In an embodiment, the first to sixth data lines DL1 to DL6 may respectively be connected to (e.g., directly connected thereto) the first to sixth input lines IL1 to IL6 to transmit a data signal to each sub-pixel.

FIGS. 4 and 5 illustrate six input lines and six data lines for convenience of explanation. However, embodiments of the present invention are not necessarily limited thereto and the numbers of the input lines IL and data lines DL may vary.

The first to sixth input lines IL1 to IL6 may be sequentially arranged in a direction from an edge of the second peripheral area PA2 to a center of the second peripheral area PA2 (e.g., in the x direction). In an embodiment, the first input line IL1, the third input line IL3, and the fifth input line IL5, which are at the odd-numbered positions, may be respectively connected to the first data line DL1, the third data line DL3, and the fifth data line DL5, which are adjacent to one another and continuously arranged. In some embodiments, the first input line IL1, the third input line IL3, and the fifth input line IL5 may be integrally formed with the first data line DL1, the third data line DL3, and the fifth data line DL5, respectively, or the first input line IL1, the third input line IL3, and the fifth input line IL5 may be respectively connected to (e.g., directly connected thereto) the first data line DL1, the third data line DL3, and the fifth data line DL5 through a first contact hole CNT1. The first input line IL1, the third input line IL3, and the fifth input line IL5 may respectively receive data signals from the first data line DL1, the third data line DL3, and the fifth data line DL5.

The second input line IL2, the fourth input line IL4, and the sixth input line IL6, which are at the even-numbered positions, may be respectively connected to the second data line DL2, the fourth data line DL4, and the sixth data line DL6, which are adjacent to one another and continuously arranged (e.g., in the -x direction). For example, the second data line DL2, the fourth data line DL4, and the sixth data line DL6 may respectively receive data signals from the second input line IL2, the fourth input line IL4, and the sixth input line IL6 through first to third data transmission lines DTL1 to DTL3.

The first to third data transmission lines DTL1 to DTL3 may be arranged to pass through the display area DA by bypassing a portion of the display area DA that is adjacent to the peripheral area PA. The second input line IL2 is electrically connected to the second data line DL2 through the first data transmission line DTL1, the fourth input line IL4 is electrically connected to the fourth data line DL4 through the second data transmission line DTL2, and the sixth input line IL6 is electrically connected to the sixth data line DL6 through the third data transmission line DTL3.

In an embodiment, an end of each of the first to third data transmission lines DTL1 to DTL3 may be connected to each of the second input line IL2, the fourth input line IL4, and the sixth input line IL6 through a second contact hole CNT2, and the other end of each of the first to third data transmission lines DTL1 to DTL3 may be connected to each of the second data line DL2, the fourth data line DL4, and the sixth data line DL6 through a third contact hole CNT3. FIGS. 4 and 5 illustrate that the second contact hole CNT2 and the third contact hole CNT3 are positioned in the peripheral area PA. However, embodiments of the present invention are not necessarily limited thereto. For example, in an embodiment, the second contact hole CNT2 and/or the third contact hole CNT3 may also be positioned in the display area DA. Accordingly, the second input line IL2 may transmit a data signal to the second data line DL2, the fourth input line IL4 may transmit a data signal to the fourth data line DL4, and the sixth input line IL6 may transmit a data signal to the sixth data line DL6.

Referring to FIG. 5, a connection relationship between the first to third data transmission lines DTL1 to DTL3 and the second input line IL2, the fourth input line IL4, the sixth input line IL6, the second data line DL2, the fourth data line DL4, and the sixth data line DL6, which are outside the display area DA where the first to third data transmission lines DTL1 to DTL3 are arranged, is shown. FIG. 5 may be understood as a schematic illustration of FIG. 4 described above.

Referring to FIG. 5, in an embodiment the second input line IL2, the fourth input line IL4, and the sixth input line IL6 may respectively be electrically connected to the second data line DL2, the fourth data line DL4, and the sixth data line DL6 through the first to third data transmission lines DTL1 to DTL3.

In an embodiment, the first to third data transmission lines DTL1 to DTL3 are shown to respectively include first connection lines DH1 to DH3, second connection lines DV1 to DV3, and third connection lines DV1' to DV3'. In an embodiment, the first connection lines DH1 to DH3 may extend in a first direction (e.g., an x direction) crossing a second direction (e.g., a y direction), and the second connection lines DV1 to DV3 and the third connection lines DV1' to DV3' may extend in the second direction (e.g., the y direction) substantially parallel to a data line.

In an embodiment, the second input line IL2, the fourth input line IL4, and the sixth input line IL6 may respectively be connected to the second connection lines DV1 to DV3 through the second contact hole CNT2, and the third connection lines DV1' to DV3' may respectively be connected to the second data line DL2, the fourth data line DL4, and the sixth data line DL6 through the third contact hole CNT3. The first connection lines DH1 to DH3 may respectively be connected to the second connection lines DV1 to DV3 and the third connection lines DV1' to DV3' through a first connection contact hole DH-CNT1 and a second connection contact hole DH-CNT2, which are respectively positioned at one end and the other end of each of the first connection lines DH1 to DH3.

In an embodiment, the first connection lines DH1 to DH3, the second connection lines DV1 to DV3, and the third connection lines DV1' to DV3' may be disposed on the same layer as each other, or at least some of them may also be disposed on different layers. For example, in an embodiment the second connection lines DV1 to DV3 and the third connection lines DV1' to DV3' may be disposed on the same layer, and the first connection lines DH1 to DH3 may be disposed on a different layer. The lines being disposed on the same layer may mean that the lines are simultaneously formed through the same mask process and include the same material as each other. As described above, when the second connection lines DV1 to DV3 and the third connection lines DV1' to DV3' are disposed on the same layer, the second connection lines DV1 to DV3 and the third connection lines DV1' to DV3' may be disposed on the same layer as the data line DL.

In an embodiment, the first connection lines DH1 to DH3 may overlap some of the first to sixth data lines DL1 to DL6 (e.g., in the z direction). The first connection lines DH1 to DH3 may be arranged to pass below the first to sixth data lines DL1 to DL6 (e.g., in the z direction). For example, as shown in FIG. 5, the first connection line DH1 may partially overlap the first data line DL1, the first connection line DH2 may partially overlap the first data line DL1, the second data line DL2, and the third data line DL3, and the first connection line DH3 may partially overlap the first data line DL1, the second data line DL2, the third data line DL3, the fourth data line DL4, and the fifth data line DL5.

In an embodiment, a dummy line may be further disposed on the same layer as each of the first connection lines DH1 to DH3, the second connection lines DV1 to DV3, and the third connection lines DV1' to DV3'. In an embodiment, the dummy line may be continuously formed with each of the first connection lines DH1 to DH3, the second connection lines DV1 to DV3, and the third connection lines DV1' to DV3', and is provided to be electrically disconnected in some areas to configure the first to third data transmission lines DTL1 to DTL3. A disconnected portion of the dummy line may be positioned around the first connection contact hole DH-CNT1 and the second connection contact hole DH-CNT2 described above. In an embodiment, the dummy line may exist in the form of a floating electrode isolated from other electrodes and/or lines, and a signal or an electrostatic voltage may also be applied to the dummy line to prevent static electricity or the like.

FIG. 6 is an equivalent circuit diagram of a sub-pixel included in a display apparatus according to an embodiment.

Referring to FIG. 6, one sub-pixel P may include a sub-pixel circuit PC and an organic light-emitting diode OLED.

For example, the sub-pixel circuit PC may include a plurality of thin-film transistors T1 to T7 and a storage capacitor Cst, as shown in FIG. 6. The plurality of thin-film transistors T1 to T7 and the storage capacitor Cst may be connected to signal lines SL1, SL2, SLp, SLn, EL, DL, a first initialization voltage line VL1, a second initialization voltage line VL2, and the driving voltage line PL. In an embodiment, at least one of the lines described above, for example, the driving voltage line PL may be shared by neighboring sub-pixels P.

In an embodiment, the plurality of thin-film transistors T1 to T7 may include a driving thin-film transistor T1, a switching thin-film transistor T2, a compensation thin-film transistor T3, a first initialization thin-film transistor T4, an operation control thin-film transistor T5, an emission control thin-film transistor T6, and a second initialization thin-film transistor T7.

In an embodiment, the organic light-emitting diode OLED may include a sub-pixel electrode (e.g., an anode) and an opposite electrode (e.g., a cathode), and the sub-pixel electrode of the organic light-emitting diode OLED may be connected to the driving thin-film transistor T1 via the emission control thin-film transistor T6 to receive a driving current, and the opposite electrode thereof may provide a common voltage ELVSS. The organic light-emitting diode OLED may emit light having a brightness corresponding to the driving current.

Some of the plurality of thin-film transistors T1 to T7 may be provided as n-channel metal-oxide-semiconductor field effect transistors (MOSFET) (NMOS), and the remaining transistors may be provided as p-channel MOSFETs (PMOS). For example, in an embodiment, among the plurality of thin-film transistors T1 to T7, the compensation thin-film transistor T3 and the first initialization thin-film transistor T4 may be provided as NMOSs, and the remaining transistors (e.g., T1, T2 and T5-T7) may be provided as PMOSs. However, embodiments of the present invention are not necessarily limited thereto.

For example, in an embodiment, among the plurality of thin-film transistors T1 to T7, the compensation thin-film transistor T3, the first initialization thin-film transistor T4, and the second initialization thin-film transistor T7 may be provided as NMOSs, and the remaining transistors (e.g., T1, T2, T5, T6) may be provided as PMOSs. Alternatively, only one of the plurality of thin-film transistors T1 to T7 may be provided as an NMOS, and the remaining transistors may be provided as a PMOS. Alternatively, all of the plurality of thin-film transistors T1 to T7 may be provided as NMOSs.

In an embodiment, the signal lines may include a first scan line SL1 configured to transmit a first scan signal Sn, a second scan line SL2 configured to transmit a second scan signal Sn', a previous scan line SLp configured to transmit a previous scan signal Sn-1 to the first initialization thin-film transistor T4, an emission control line EL configured to transmit an emission control signal En to the operation control thin-film transistor T5 and the emission control thin-film transistor T6, a next scan line SLn configured to transmit a next scan signal Sn+1 to the second initialization thin-film transistor T7, and a data line DL crossing the first scan line SL1 and configured to transmit a data signal Dm.

In an embodiment, the driving voltage line PL may be configured to transmit a driving voltage ELVDD to the driving thin-film transistor T1, and the first initialization voltage line VL1 may be configured to transmit a first initialization voltage Vint that initializes the driving thin-film transistor T1 and the sub-pixel electrode of the organic light-emitting diode OLED.

A driving gate electrode of the driving thin-film transistor T1 may be connected to the storage capacitor Cst, a driving source area of the driving thin-film transistor T1 may be connected to the driving voltage line PL via the operation control thin-film transistor T5, and a driving drain area of the driving thin-film transistor T1 may be electrically connected to the sub-pixel electrode of the organic light-emitting diode OLED via the emission control thin-film transistor T6. The driving thin-film transistor T1 may receive the data signal Dm in response to a switching operation of the switching thin-film transistor T2 and supply a driving current to the organic light-emitting diode OLED.

A switching gate electrode of the switching thin-film transistor T2 may be connected to the first scan line SL1 configured to transmit the first scan signal Sn, a switching source area of the switching thin-film transistor T2 may be connected to the data line DL, and a switching drain area of the switching thin-film transistor T2 may be connected to the driving source area of the driving thin-film transistor T1 and connected to the driving voltage line PL via the operation control thin-film transistor T5. In an embodiment, the switching thin-film transistor T2 may be turned on in response to the first scan signal Sn received through the first scan line SL1 and may perform a switching operation of transmitting the data signal Dm transmitted through the data line DL to the driving source area of the driving thin-film transistor T1.

In an embodiment, a compensation gate electrode of the compensation thin-film transistor T3 is connected to the second scan line SL2. A compensation drain area of the compensation thin-film transistor T3 may be connected to the sub-pixel electrode of the organic light-emitting diode OLED via the emission control thin-film transistor T6 while being connected to the driving drain area of the driving thin-film transistor T1. A compensation source area of the compensation thin-film transistor T3 may be connected to a first electrode CE1 of the storage capacitor Cst and the driving gate electrode of the driving thin-film transistor T1. In addition, the compensation source area may be connected to a first initialization drain area of the first initialization thin-film transistor T4.

In an embodiment, the compensation thin-film transistor T3 may be turned on in response to the second scan signal Sn' received through the second scan line SL2 and electrically connected to the driving gate electrode and the driving drain area of the driving thin-film transistor T1 to diode-connect the driving thin-film transistor T1.

In an embodiment, a first initialization gate electrode of the first initialization thin-film transistor T4 may be connected to the previous scan line SLp. A first initialization source area of the first initialization thin-film transistor T4 may be connected to a second initialization source area of the second initialization thin-film transistor T7 and the first initialization voltage line VL1. The first initialization drain area of the first initialization thin-film transistor T4 may be connected to the first electrode CE1 of the storage capacitor Cst, the compensation source area of the compensation thin-film transistor T3, and the driving gate electrode of the driving thin-film transistor T1. In an embodiment, the first initialization thin-film transistor T4 may be turned on in response to the previous scan signal Sn-1 received through the previous scan line SLp and configured to transmit the first initialization voltage Vint to the driving gate electrode of the driving thin-film transistor T1 to perform an initialization operation of initializing a voltage of the driving gate electrode of the driving thin-film transistor T1.

In an embodiment, an operation control gate electrode of the operation control thin-film transistor T5 may be connected to the emission control line EL, an operation control source area of the operation control thin-film transistor T5 may be connected to the driving voltage line PL, and an operation control drain area of the operation control thin-film transistor T5 may be connected to the driving source area of the driving thin-film transistor T1 and the switching drain area of the switching thin-film transistor T2.

In an embodiment, an emission control gate electrode of the emission control thin-film transistor T6 may be connected to the emission control line EL, an emission control source area of the emission control thin-film transistor T6 may be connected to the driving drain area of the driving thin-film transistor T1 and the compensation drain area of the compensation thin-film transistor T3, and an emission control drain area of the emission control thin-film transistor T6 may be electrically connected to a second initialization drain area of the second initialization thin-film transistor T7 and the sub-pixel electrode of the organic light-emitting diode OLED.

In an embodiment, the operation control thin-film transistor T5 and the emission control thin-film transistor T6 may be turned on in response to the emission control signal En received through the emission control line EL, and the driving voltage ELVDD may be transmitted to the organic light-emitting diode OLED to allow a driving current flows through the organic light-emitting diode OLED.

In an embodiment, a second initialization gate electrode of the second initialization thin-film transistor T7 may be connected to the next scan line SLn, a second initialization drain area of the second initialization thin-film transistor T7 may be connected to the emission control drain area of the emission control thin-film transistor T6 and the sub-pixel electrode of the organic light-emitting diode OLED, and the second initialization source area of the second initialization thin-film transistor T7 may be connected to the second initialization voltage line VL2 to receive a second initialization voltage Aint. In an embodiment, the second initialization thin-film transistor T7 may be turned on in response to the next scan signal Sn+1 received through the next scan line SLn and initialize the sub-pixel electrode of the organic light-emitting diode OLED.

The second initialization thin-film transistor T7 may be connected to the next scan line SLn, as shown in FIG. 6. However, embodiments of the present invention are not necessarily limited thereto. For example, in an embodiment, the second initialization thin-film transistor T7 may be connected to the emission control line EL to be driven in response to the emission control signal En. The positions of source areas and drain areas of the plurality of thin-film transistors T1 to T7 may be changed according to the type (e.g., a p-type or an n-type) of a transistor.

In an embodiment, the storage capacitor Cst may include the first electrode CE1 and a second electrode CE2. The first electrode CE1 of the storage capacitor Cst is connected to the driving gate electrode of the driving thin-film transistor T1, and the second electrode CE2 of the storage capacitor Cst is connected to the driving voltage line PL. The storage capacitor Cst may store a charge corresponding to a difference between a voltage of the driving gate electrode of the driving thin-film transistor T1 and the driving voltage ELVDD.

In an embodiment, a boosting capacitor Cbs may include a first electrode CE1' and a second electrode CE2'. The first electrode CE1' of the boosting capacitor Cbs may be connected to the first electrode CE1 of the storage capacitor Cst, and the second electrode CE2' of the boosting capacitor Cbs may receive the first scan signal Sn. The boosting capacitor Cbs may compensate for a voltage drop at the driving gate electrode of the driving thin-film transistor T1 by increasing a voltage of the driving gate electrode of the driving thin-film transistor T1 at a time point in which the supply of the first scan signal Sn is stopped.

A detailed operation of each sub-pixel P according to an embodiment is as follows.

In an embodiment, during an initialization period, when the previous scan signal Sn-1 is supplied through the previous scan line SLp, the first initialization thin-film transistor T4 is turned on in response to the previous scan signal Sn-1, and the driving thin-film transistor T1 is initialized by the first initialization voltage Vint supplied from the first initialization voltage line VL1.

In an embodiment, during a data programming period, when the first scan signal Sn and the second scan signal Sn' are respectively provided through the first scan line SL1 and the second scan line SL2, the switching thin-film transistor T2 and the compensation thin-film transistor T3 are turned on in response to the first scan signal Sn and the second scan signal Sn'. At this time, the driving thin-film transistor T1 is diode-connected by the compensation thin-film transistor T3 which is turned on, and is biased in a forward direction.

In an embodiment, a compensation voltage Dm+Vth (in which Vth is a value of (-)) obtained by reducing a threshold voltage Vth of the driving thin-film transistor T1 from the data signal Dm supplied from the data line DL is applied to the driving gate electrode of the driving thin-film transistor T1.

In an embodiment, the driving voltage ELVDD and the compensation voltage Dm+Vth are applied to both ends of the storage capacitor Cst, and a charge corresponding to a voltage difference between the both ends of the storage capacitor Cst is stored in the storage capacitor Cst.

In an embodiment, during an emission period, the operation control thin-film transistor T5 and the emission control thin-film transistor T6 are turned on by the emission control signal En supplied from the emission control line EL. A driving current is generated according to a voltage difference between a voltage of the driving gate electrode of the driving thin-film transistor T1 and the driving voltage ELVDD, and the driving current is supplied to the organic light-emitting diode OLED through the emission control thin-film transistor T6.

In an embodiment, at least one of the plurality of thin-film transistors T1 to T7 includes a semiconductor layer including an oxide, and the others include a semiconductor layer including silicon.

For example, in an embodiment, the driving thin-film transistor T1 which directly affects the brightness of a display apparatus may be configured to include a semiconductor layer including polycrystalline silicon having high reliability, thereby implementing a display apparatus having high resolution.

Since an oxide semiconductor has high carrier mobility and low leakage current, a voltage drop is relatively small even when a driving time is relatively long. For example, since color change of an image according to a voltage drop is relatively small even during low-frequency driving, the low-frequency driving is possible.

In an embodiment, since an oxide semiconductor has low leakage current, at least one of the compensation thin-film transistor T3, the first initialization thin-film transistor T4, and the second initialization thin-film transistor T7, which is connected to the driving gate electrode of the driving thin-film transistor T1, may include an oxide semiconductor, thereby preventing leakage current that may flow to the driving gate electrode of the driving thin-film transistor T1 and reducing power consumption.

Although FIG. 6 illustrates that the sub-pixel circuit PC includes seven transistors and two capacitors, embodiments of the present invention are not necessarily limited thereto. For example, in an embodiment, the sub-pixel circuit PC may include less than seven or eight or more transistors. For example, in an embodiment the sub-pixel circuit PC may include eight transistors. However, the number of transistors and capacitors included in the sub-pixel circuit PC may vary as necessary.

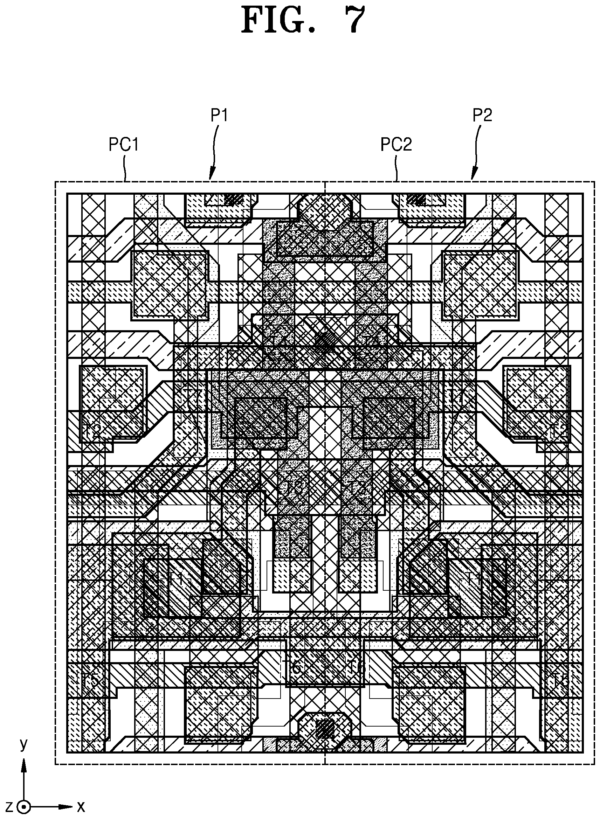

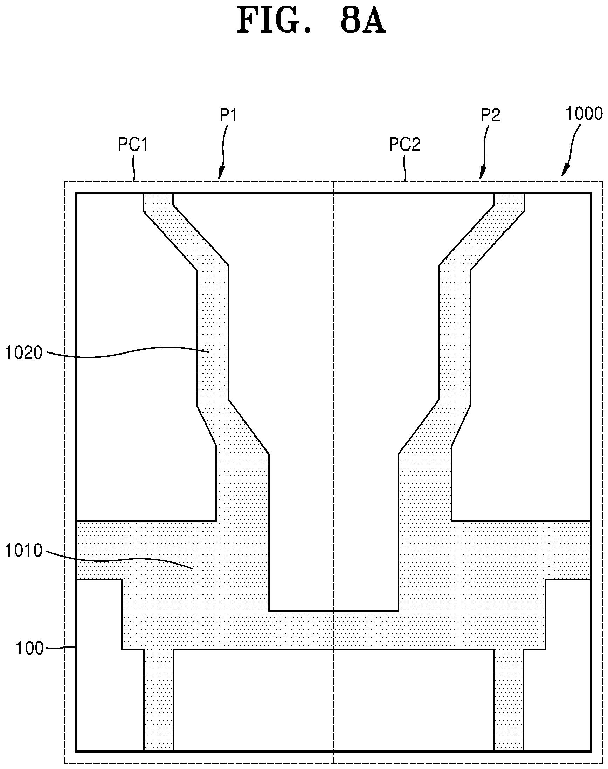

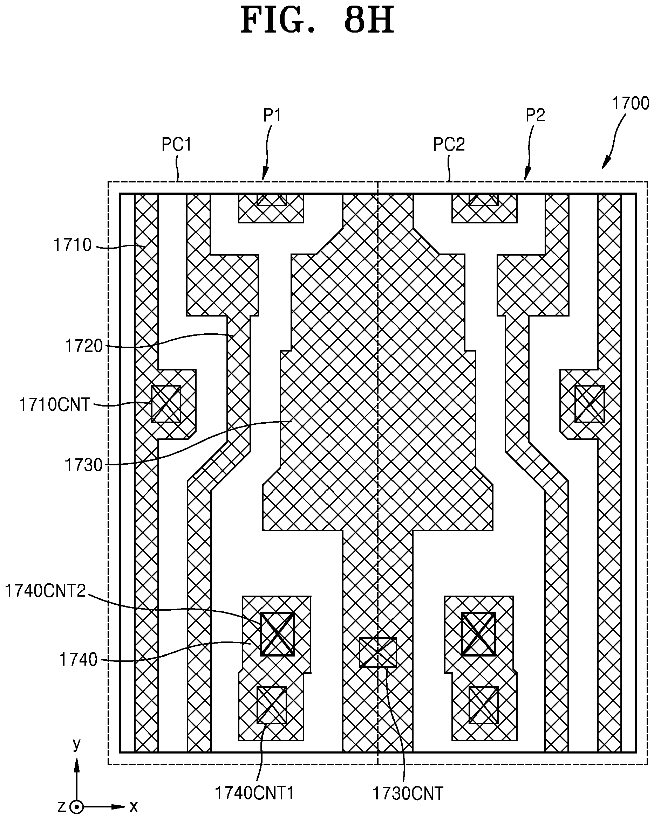

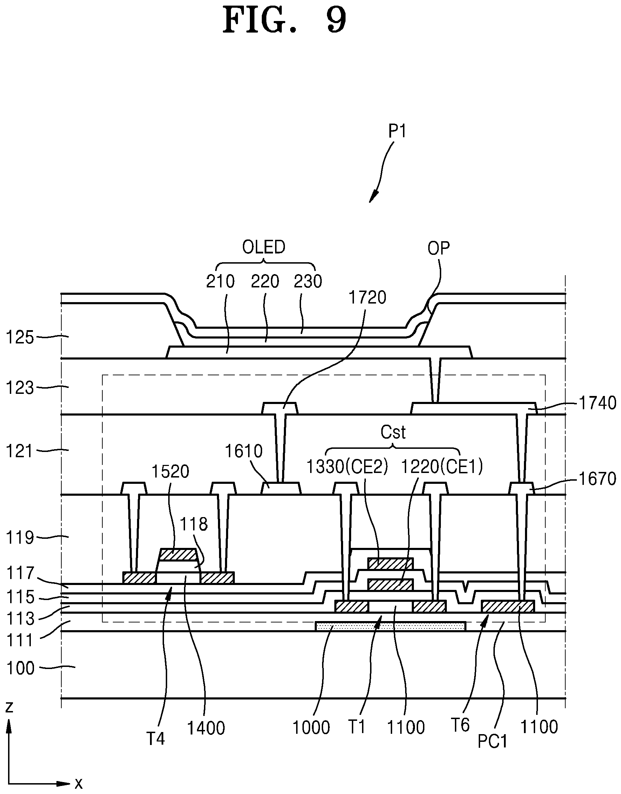

FIG. 7 is a schematic plan view illustrating a structure of a sub-pixel circuit according to an embodiment, FIGS. 8A to 8H are plan views illustrating components configuring the sub-pixel circuit of FIG. 7 for each layer, and FIG. 9 is a schematic cross-sectional view illustrating a portion of a sub-pixel circuit according to an embodiment.

Referring to FIGS. 7, 8A, and 9, a display apparatus may include a first sub-pixel P1 and a second sub-pixel P2, which are adjacent to each other (e.g., in the x direction). In an embodiment, as shown in FIG. 7, the first sub-pixel P1 and the second sub-pixel P2 may have a symmetrical structure to each other with respect to a virtual line. However, embodiments of the present invention are not necessarily limited thereto. For example, in an embodiment, the first sub-pixel P1 and the second sub-pixel P2 may also have a structure in which the same sub-pixel structure is continuously repeated, instead of a symmetrical structure. The first sub-pixel P1 may include a first sub-pixel circuit PC1, and the second sub-pixel P2 may include a second sub-pixel circuit PC2.

Hereinafter, for convenience of description, some conductive patterns will be described based on the first sub-pixel circuit PC1. However, these conductive patterns may also be symmetrically arranged in the second sub-pixel circuit PC2.

In an embodiment, the substrate 100 may include glass, quartz, plastic, or the like. In an embodiment, the substrate 100 may include plastic, and accordingly, the display apparatus may be flexible. In this embodiment, the substrate 100 may have a structure in which at least one organic film layer and at least one barrier layer are alternately stacked (e.g., in the z direction). For example, in an embodiment the organic film layer may be formed by using an organic material such as polyimide, and the barrier layer may be formed by using an inorganic material.

A first conductive pattern 1000 may be disposed on the substrate 100 (e.g., disposed directly thereon in the z direction). In an embodiment, a main portion 1010 may be disposed in each of the first sub-pixel circuit PC1 and the second sub-pixel circuit PC2, which are adjacent to the first conductive pattern 1000. The main portion 1010 may be connected to (e.g., directly connected thereto) another portion hereinafter referred to as a branch portion 1020 that extends in a first direction (e.g., an x direction) or a second direction (e.g., a y direction). In an embodiment, the main portion 1010 of the first sub-pixel circuit PC1 may be directly connected to the main portion 1010 of the second sub-pixel circuit PC2. The main portion 1010 of the first conductive pattern 1000 may overlap (e.g., in the z direction) a first active pattern 1100 and a first gate electrode 1220 of the driving thin-film transistor T1.

In an embodiment, the first conductive pattern 1000 may include a metal, an alloy, a conductive metal oxide, a transparent conductive material, or the like. For example, the first conductive pattern 1000 may include silver (Ag), an alloy containing Ag, molybdenum (Mo), an alloy containing Mo, aluminum (Al), an alloy containing Al, aluminum nitride (AIN), tungsten (W), tungsten nitride (WN), copper (Cu), nickel (Ni), chromium (Cr), chromium nitride (CrN), titanium (Ti), tantalum (Ta), platinum (Pt), scandium (Sc), indium tin oxide (ITO), indium zinc oxide (IZO), or the like.

In an embodiment, a buffer layer 111 (refer to FIG. 9) may be disposed on (e.g., disposed directly thereon) the first conductive pattern 1000. The buffer layer 111 may prevent a phenomenon in which metal atoms or impurities diffuse from the substrate 100 into the first active pattern 1100 from occurring. In addition, the buffer layer 111 may adjust a heat supply rate during a crystallization process for forming the first active pattern 1100 so that the first active pattern 1100 may be uniformly formed.

Referring to FIGS. 7, 8B, and 9, the first active pattern 1100 may be disposed on (e.g., disposed directly thereon) the buffer layer 111. In an embodiment, the first active pattern 1100 may include a silicon semiconductor. For example, the silicon semiconductor may include amorphous silicon, polycrystalline silicon, or the like. For example, the first active pattern 1100 may include low-temperature polysilicon (LTPS).

In an embodiment, ions may be implanted into the first active pattern 1100. For example, in an embodiment in which the driving thin-film transistor T1, the switching thin-film transistor T2, the operation control thin-film transistor T5, the emission control thin-film transistor T6, and the second initialization thin-film transistor T7 are PMOSs, ions such as boron may be implanted into the first active pattern 1100.

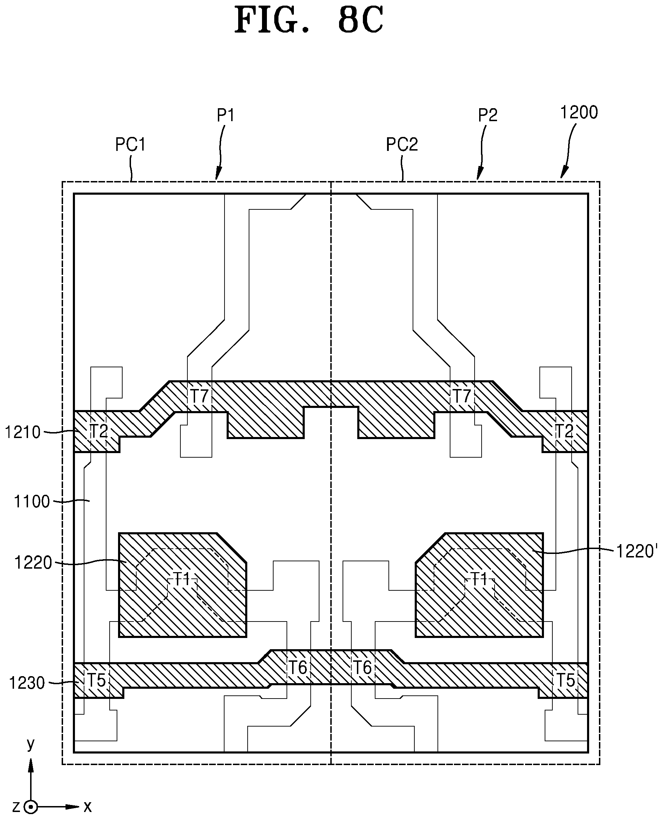

In an embodiment, a portion of the first active pattern 1100 may be referred to as a third active pattern 1100', wherein the portion corresponds to the second sub-pixel circuit PC2. A third gate electrode 1220' may be disposed on the third active pattern 1100', as shown in FIG. 8C.

A first gate insulating layer 113 (refer to FIG. 9) may cover the first active pattern 1100 and may be disposed above the substrate 100. The first gate insulating layer 113 may include an insulating material. For example, in an embodiment the first gate insulating layer 113 may include silicon oxide, silicon nitride, silicon oxynitride, aluminum oxide, or the like.

Referring to FIGS. 7, 8C, and 9, a second conductive pattern 1200 may be disposed on (e.g., disposed directly thereon) the first gate insulating layer 113. In an embodiment, the second conductive pattern 1200 may include a first gate line 1210, the first gate electrode 1220, and a second gate line 1230.

In an embodiment, the first gate line 1210 may extend in the first direction (e.g., the x direction). The first gate line 1210 may correspond to the first scan line SL1 of FIG. 6. The first gate line 1210 may configure the switching thin-film transistor T2 together with the first active pattern 1100. For example, in an embodiment the first scan signal Sn may be provided through the first gate line 1210. In addition, the first gate line 1210 may configure the second initialization thin-film transistor T7 together with the first active pattern 1100. For example, in an embodiment the next scan signal Sn+1 may be provided through the first gate line 1210. In an embodiment, the first scan signal Sn and the next scan signal Sn+1 may have substantially the same waveform with a time difference.

In an embodiment, the first gate electrode 1220 may be arranged in an island shape. In an embodiment, the first gate electrode 1220 may configure the driving thin-film transistor T1 together with the first active pattern 1100.

In an embodiment, the second gate line 1230 may extend in the first direction (e.g., the x direction). The second gate line 1230 may correspond to the emission control line EL of FIG. 6. In an embodiment, the second gate line 1230 may configure the operation control thin-film transistor T5 and the emission control thin-film transistor T6 together with the first active pattern 1100. For example, in an embodiment the emission control signal En may be provided through the second gate line 1230.

In an embodiment, the second conductive pattern 1200 may include a metal, an alloy, a conductive metal oxide, a transparent conductive material, or the like.

A second gate insulating layer 115 (e.g., a second gate insulating layer 115 of FIG. 9) may cover the second conductive pattern 1200 and may be disposed on (e.g., disposed directly thereon) the first gate insulating layer 113. Like the first gate insulating layer 113, the second gate insulating layer 115 may include an insulating material.

Referring to FIGS. 7, 8D, and 9, a third conductive pattern 1300 may be disposed on the second gate insulating layer 115. In an embodiment, the third conductive pattern 1300 may include a third gate line 1310, a fourth gate line 1320, a storage capacitor electrode 1330 (e.g., the second electrode CE2 of FIG. 6), and a first initialization voltage line 1340 (e.g., the first initialization voltage line VL1 of FIG. 6).

In an embodiment, the third gate line 1310 may extend in the first direction (e.g., the x direction). The third gate line 1310 may correspond to the previous scan line SLp of FIG. 6. In an embodiment, the third gate line 1310 may be spaced apart from the first gate line 1210 in a plan view. The previous scan signal Sn-1 may be provided through the third gate line 1310.

In an embodiment, the fourth gate line 1320 may extend in the first direction (e.g., the x direction). The fourth gate line 1320 may correspond to the second scan line SL2 of FIG. 6. The fourth gate line 1320 may be spaced apart from the first gate line 1210 and the third gate line 1310 in a plan view (e.g., in the y direction). The second scan signal Sn' may be provided through the fourth gate line 1320.

The storage capacitor electrode 1330 may overlap (e.g., in the z direction) the first gate electrode 1220 and extend in the first direction (e.g., the x direction). For example, the storage capacitor electrode 1330 may configure the storage capacitor Cst together with the first gate electrode 1220. The driving voltage ELVDD may be provided through the storage capacitor electrode 1330. In addition, in an embodiment an opening 1330-OP penetrating the storage capacitor electrode 1330 may be formed in the storage capacitor electrode 1330, and the first gate electrode 1220 may be exposed through the opening 1330-OP.

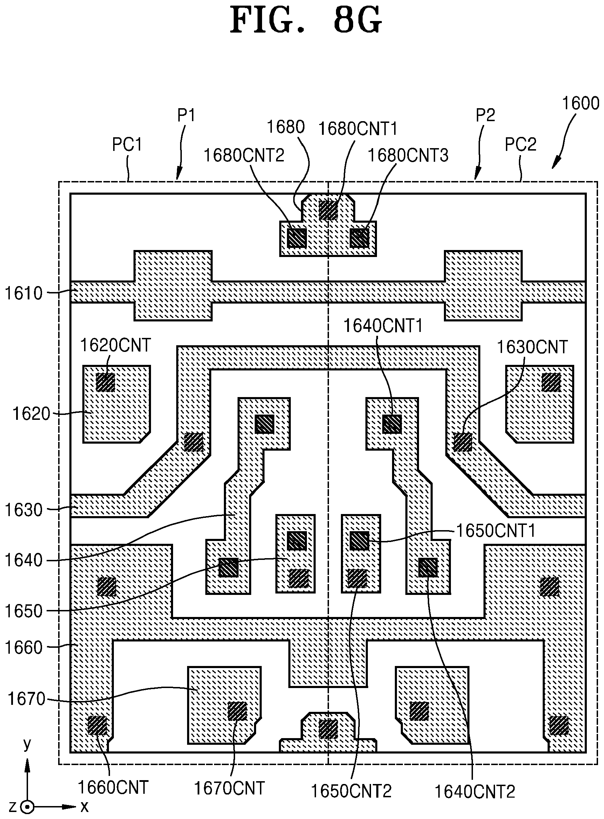

The first initialization voltage line 1340 may extend in the first direction (e.g., the x direction). The first initialization voltage line 1340 may be spaced apart from the third gate line 1310 in a plan view (e.g., in the y direction). The first initialization voltage Vint may be provided through the first initialization voltage line 1340. The first initialization voltage line 1340 may at least partially overlap a second active pattern 1400 to be described below, and may transmit the first initialization voltage Vint to the second active pattern 1400. In an embodiment, the first initialization voltage line 1340 may be electrically connected to the second active pattern 1400 through contact holes 1680CNT1, 1680CNT2, and 1680CNT3 to be described below with reference to FIG. 8G. The first initialization voltage line 1340 may be the first initialization voltage line VL1 of FIG. 6.

In an embodiment, the third conductive pattern 1300 may include, for example, a metal, an alloy, a conductive metal oxide, a transparent conductive material, or the like.

In an embodiment, a first interlayer insulating layer 117 (refer to FIG. 9) may cover the third conductive pattern 1300 and may be disposed on the second gate insulating layer 115. The first interlayer insulating layer 117 may include an insulating material. For example, in an embodiment the first interlayer insulating layer 117 may include silicon oxide, silicon nitride, silicon oxynitride, aluminum oxide, or the like.

Referring to FIGS. 7, 8E, and 9, the second active pattern 1400 may be disposed on the first interlayer insulating layer 117. In an embodiment, the second active pattern 1400 may include an oxide semiconductor. The second active pattern 1400 may be disposed on a different layer from the first active pattern 1100 and may not overlap the first active pattern 1100 (e.g., in the z direction).

A third gate insulating layer 118 may cover the second active pattern 1400 and may be disposed on the first interlayer insulating layer 117. The third gate insulating layer 118 may include an insulating material.

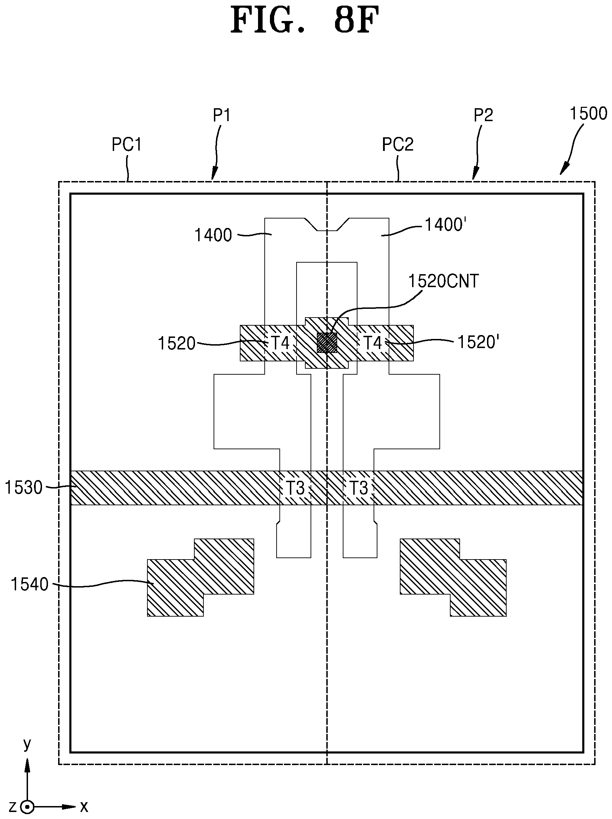

In an embodiment, as shown in FIG. 9, the third gate insulating layer 118 may be patterned to cover a portion of the second active pattern 1400 and expose a remaining portion of the second active pattern 1400. In an embodiment, the third gate insulating layer 118 may be formed in the same pattern as a second gate electrode 1520 to be described below with reference to FIG. 8F. Accordingly, a source area and a drain area of the second active pattern 1400 may be exposed except for a channel area overlapping the second gate electrode 1520. The source area and the drain area may be in direct contact with a second interlayer insulating layer 119, as shown in FIG. 9.

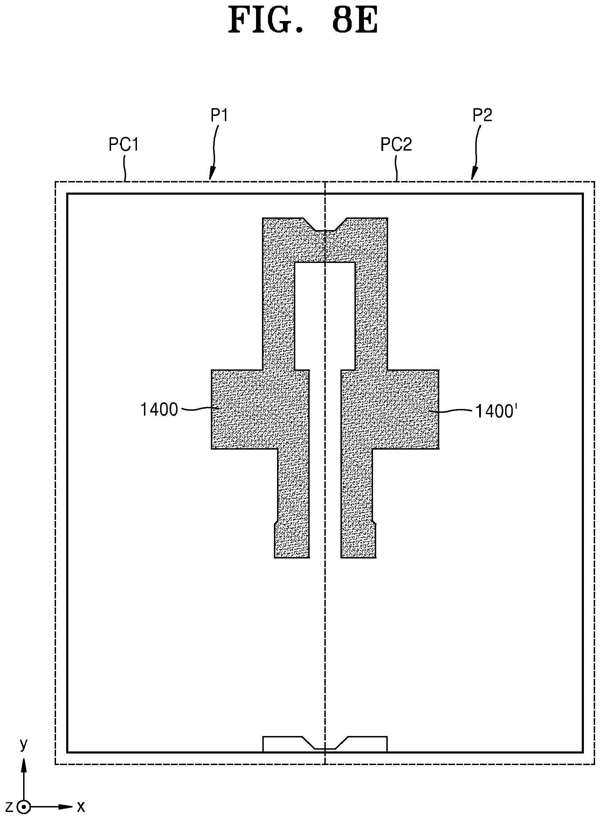

In an embodiment, in FIG. 8E, a portion corresponding to the second pixel circuit PC2 may be referred to as a fourth active pattern 1400' In this embodiment, when a portion corresponding to the first sub-pixel circuit PC1 is referred to as the second active pattern 1400, and a portion corresponding to the second sub-pixel circuit PC2 is referred to as the fourth active pattern 1400', the second active pattern 1400 and the fourth active pattern 1400' may be seen as being provided as an integral body.

Referring to FIGS. 7, 8F, and 9, a fourth conductive pattern 1500 may be disposed on (e.g., disposed directly thereon) the third gate insulating layer 118. In an embodiment, the fourth conductive pattern 1500 may include the second gate electrode 1520, a fifth gate line 1530, and a first transmission pattern 1540.

In an embodiment, the second gate electrode 1520 (e.g., a gate pattern) may overlap the third gate line 1310 and the second active pattern 1400 (e.g., in the z direction). For example, the second active pattern 1400 may at least partially overlap the second gate electrode 1520 in a plan view. In an embodiment, the second gate electrode 1520 may be electrically connected to the third gate line 1310. For example, in an embodiment the second gate electrode 1520 may be in direct contact with the third gate line 1310 through a contact hole 1520CNT. The contact hole 1520CNT may be formed to penetrate insulating layers (e.g., the first interlayer insulating layer 117 and the third gate insulating layer 118) between the third gate line 1310 and the second gate electrode 1520.

In an embodiment, the second scan signal Sn' may be provided through the second gate electrode 1520. The third gate line 1310, the second active pattern 1400, and the second gate electrode 1520 may configure the first initialization thin-film transistor T4. For example, the third gate line 1310 may correspond to a back-gate electrode of the first initialization thin-film transistor T4, and the second gate electrode 1520 may correspond to a gate electrode of the first initialization thin-film transistor T4.

A portion of the second gate electrode 1520 may be referred to as a fourth gate electrode 1520', the portion corresponding to the second sub-pixel circuit PC2. The fourth gate electrode 1520' may overlap the fourth active pattern 1400' (e.g., in the z direction) to configure the first initialization thin-film transistor T4 in the second sub-pixel circuit PC2.

In an embodiment, the fifth gate line 1530 may extend in the first direction (e.g., the x direction). The fifth gate line 1530 may overlap the fourth gate line 1320 and the second active pattern 1400 (e.g., in the z direction). In some embodiments, the fifth gate line 1530 may be electrically connected to the fourth gate line 1320. For example, in an embodiment the fifth gate line 1530 may be in direct contact with the fourth gate line 1320 through a contact hole.

The second scan signal Sn' may be provided through the fifth gate line 1530. In an embodiment, the fourth gate line 1320, the second active pattern 1400, and the fifth gate line 1530 may configure the compensation thin-film transistor T3. For example, the fourth gate line 1320 may correspond to a back-gate electrode of the compensation thin-film transistor T3, and the fifth gate line 1530 may correspond to a gate electrode of the compensation thin-film transistor T3.

In an embodiment, the first transmission pattern 1540 may be in direct contact with the first gate electrode 1220 exposed through the opening 1330-OP of the storage capacitor electrode 1330. The first transmission pattern 1540 may transmit the first initialization voltage Vint to the first gate electrode 1220.

The second interlayer insulating layer 119 may be arranged to cover at least a portion of the fourth conductive pattern 1500 of FIG. 8F. The second interlayer insulating layer 119 may include an insulating material. For example, in an embodiment the second interlayer insulating layer 119 may include silicon oxide, silicon nitride, silicon oxynitride, aluminum oxide, or the like.

Referring to FIGS. 7, 8G, and 9, a fifth conductive pattern 1600 may be disposed on (e.g., disposed directly thereon) the second interlayer insulating layer 119. In an embodiment, the fifth conductive pattern 1600 may include a first connection line 1610, a second transmission pattern 1620, a second initialization voltage line 1630, a third transmission pattern 1640, a fourth transmission pattern 1650, a fifth transmission pattern 1660, a sixth transmission pattern 1670 and a seventh transmission pattern 1680.

In an embodiment, the first connection line 1610 may extend in the first direction (e.g., the x direction). The data signal Dm may be provided through the first connection line 1610.

In an embodiment, the second transmission pattern 1620 may be in direct contact with the first active pattern 1100 through a contact hole 1620CNT. The data signal Dm may be transmitted to the first active pattern 1100 through the second transmission pattern 1620.

In an embodiment, the second initialization voltage line 1630 (e.g., the second initialization voltage line VL2 of FIG. 6) may extend in the first direction (e.g., the x direction). The second initialization voltage Aint may be provided through the second initialization voltage line 1630. In an embodiment, the second initialization voltage line 1630 may be in direct contact with the first active pattern 1100 through a contact hole 1630CNT and may transmit the second initialization voltage Aint to the first active pattern 1100.

In an embodiment, the third transmission pattern 1640 may be in direct contact with the second active pattern 1400 and the first transmission pattern 1540 through contact holes 1640CNT1 and 1640CNT2 respectively provided on one side and the other side (e.g., in the y direction) of the third transmission pattern 1640. In an embodiment, the first initialization voltage Vint may be transmitted to the first gate electrode 1220 through the second active pattern 1400, the third transmission pattern 1640, and the first transmission pattern 1540.

In an embodiment, the fourth transmission pattern 1650 may be in direct contact with the second active pattern 1400 and the first active pattern 1100 through contact holes 1650CNT1 and 1650CNT2 respectively provided on one side and the other side (e.g., in the y direction) of the fourth transmission pattern 1650. The fourth transmission pattern 1650 may electrically connect the second active pattern 1400 to the first active pattern 1100.

In an embodiment, the fifth transmission pattern 1660 may extend in the first direction (e.g., the x direction). The driving voltage ELVDD may be provided through the fifth transmission pattern 1660. In an embodiment, the fifth transmission pattern 1660 may be in direct contact with the first active pattern 1100 through a contact hole 1660CNT and may transmit the driving voltage ELVDD to the first active pattern 1100.

In an embodiment, the sixth transmission pattern 1670 may be in direct contact with the first active pattern 1100 through a contact hole 1670CNT. The sixth transmission pattern 1670 may transmit a driving current or the second initialization voltage Aint from the first active pattern 1100 to the organic light-emitting diode OLED.

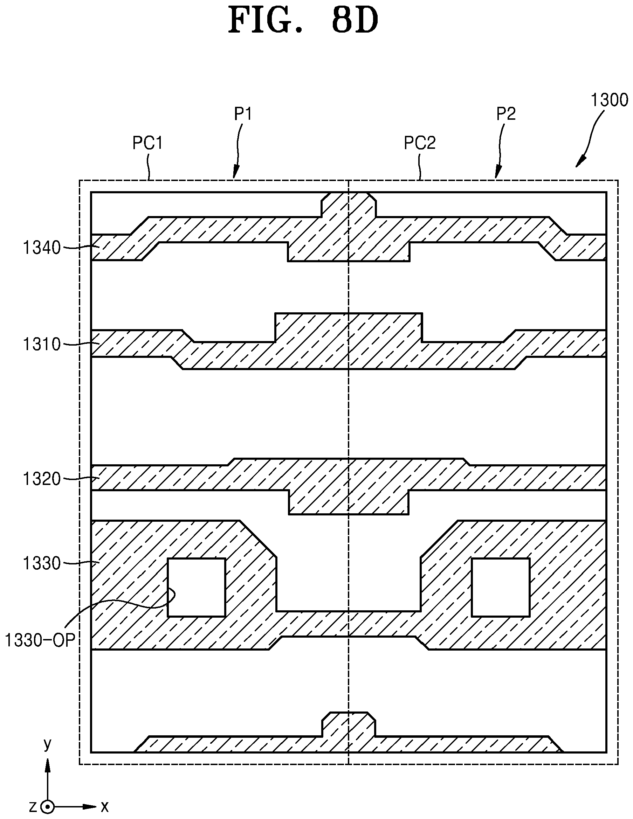

In an embodiment, the seventh transmission pattern 1680 may be in direct contact with the second active pattern 1400 through contact holes 1680CNT1, 1680CNT2, and 1680CNT3. The seventh transmission pattern 1680 may transmit the first initialization voltage Vint to the first initialization thin-film transistor T4 by being in direct contact with the first initialization voltage line 1340 of FIG. 8D through the contact hole 1680CNT1 and being in direct contact with the second active pattern 1400 of FIG. 8E through the contact holes 1680CNT2 and 1680CNT3.

In an embodiment, a first planarization insulating layer 121 may cover the fifth conductive pattern 1600 and may be disposed on (e.g., disposed directly thereon) the second interlayer insulating layer 119. In an embodiment, the first planarization insulating layer 121 may include an organic insulating material. For example, in an embodiment the first planarization insulating layer 121 may include photoresist, polyacrylic resin, polyimide resin, acrylic resin, or the like.

Referring to FIGS. 7, 8H, and 9, a sixth conductive pattern 1700 may be disposed on (e.g., disposed directly thereon) the first planarization insulating layer 121. In an embodiment, the sixth conductive pattern 1700 may include a data line 1710, a second connection line 1720, a voltage line 1730, and an eighth transmission pattern 1740.

In an embodiment, the data line 1710 may extend in the second direction (e.g., the y direction). In an embodiment, the data line 1710 may correspond to the data line DL of FIG. 6. The data line 1710 may be connected to the second transmission pattern 1620 through a contact hole 1710CNT. The data signal Dm may be transmitted to the first active pattern 1100 through the data line 1710 and the second transmission pattern 1620.

In an embodiment, the second connection line 1720 may extend in the second direction (e.g., the y direction). In an embodiment, the second connection line 1720 may be in direct contact with the first connection line 1610.

In an embodiment in which the first sub-pixel P1 and the second sub-pixel P2 are disposed on a lower side (e.g., in the -y direction) of the display panel 10 of FIG. 3, for example, adjacent to a first edge E1, the first connection line 1610 may correspond to the first connection lines DH1 to DH3 described above with reference to FIG. 5, the data line 1710 may correspond to the first to sixth data lines DL1 to DL6 described above with reference to FIG. 5, and the second connection line 1720 may correspond to the second connection lines DV1 to DV3 or the third connection lines DV1' to DV3' described above with reference to FIG. 5. For example, different data voltages may be provided to the data line 1710 and the second connection line 1720. For example, a first data voltage may be transmitted to the first active pattern 1100 through the data line 1710, and a second data voltage that is different from the first data voltage may be transmitted to the first connection line 1610 through the second connection line 1720.

In an embodiment in which the first sub-pixel P1 and the second sub-pixel P2 are disposed on an upper side (e.g., in the y direction) of the display panel 10 of FIG. 3, for example, adjacent to the second edge E2, the first connection line 1610 and the second connection line 1720 may be common voltage lines electrically connected to the second power supply line 16 of FIG. 3. In an embodiment, the common voltage lines may be electrically connected to an opposite electrode 230 (refer to FIG. 9) of the organic light-emitting diode OLED to transmit the common voltage ELVSS to the organic light-emitting diode OLED. For example, the first connection line 1610 may be a horizontal common voltage line, and the second connection line 1720 may be a vertical common voltage line.

In an embodiment, the voltage line 1730 may extend in the second direction (e.g., the y direction). The voltage line 1730 may correspond to the driving voltage line PL of FIG. 6. The voltage line 1730 may provide the driving voltage ELVDD. In an embodiment, the voltage line 1730 may be connected to (e.g., directly connected thereto) the fifth transmission pattern 1660 through a contact hole 1730CNT and may provide the driving voltage ELVDD to the storage capacitor electrode 1330 and the operation control thin-film transistor T5.

In an embodiment, the voltage line 1730 may be shared by the first sub-pixel circuit PC1 and the second sub-pixel circuit PC2, which are adjacent to each other. However, embodiments of the present invention are not necessarily limited thereto. For example, in an embodiment the voltage line 1730 may be separately provided in each of the first sub-pixel circuit PC1 and the second sub-pixel circuit PC2.

In an embodiment, the eighth transmission pattern 1740 may be in direct contact with the sixth transmission pattern 1670 through a contact hole 1740CNT. The eighth transmission pattern 1740 may transmit a driving current or the second initialization voltage Aint from the sixth transmission pattern 1670 to the organic light-emitting diode OLED.

In an embodiment, the eighth transmission pattern 1740 may also be in direct contact with a sub-pixel electrode 210 (refer to FIG. 9) through a contact hole 1740CNT2. The emission control thin-film transistor T6 may be electrically connected to the sub-pixel electrode 210 through the eighth transmission pattern 1740.

In an embodiment, a second planarization insulating layer 123 may cover the sixth conductive pattern 1700 and may be disposed on (e.g., disposed directly thereon) the first planarization insulating layer 121. The second planarization insulating layer 123 may include an organic insulating material. For example, in an embodiment each of the first planarization insulating layer 121 and the second planarization insulating layer 123 may include benzocyclobutene (BCB), polyimide, hexamethyldisiloxane (HMDSO), a general commercial polymer such as polymethylmethacrylate(PMMA) or polystyrene (PS), a polymer derivative having a phenol group, an acrylic polymer, an imide polymer, an aryl ether polymer, an amide polymer, a fluorine polymer, a p-xylene polymer, a vinyl alcohol polymer, a mixture thereof, or the like.

Referring to FIG. 9, the organic light-emitting diode OLED is disposed on (e.g., disposed directly thereon) the second planarization insulating layer 123. The organic light-emitting diode OLED may include the sub-pixel electrode 210, an intermediate layer 220 including an organic emission layer, and the opposite electrode 230.

In an embodiment, the sub-pixel electrode 210 may include a (semi-transparent electrode or a reflective electrode. For example, in an embodiment, the sub-pixel electrode 210 may include a reflective layer including Ag, magnesium (Mg), Al, Pt, gold (Au), Ni, neodymium (Nd), iridium (Ir), Cr, a compound thereof, or the like, and a transparent or semi-transparent electrode layer formed on the reflective layer. The transparent or semi-transparent electrode layer may include at least one selected from a group consisting of indium tin oxide (ITO), indium zinc oxide (IZO), a zinc oxide (ZnO), indium oxide (In₂O₃), indium gallium oxide (IGO), and aluminum oxide (AZO). For example, the sub-pixel electrode 210 may include ITO/Ag/ITO.

In an embodiment, a bank layer 125 may be disposed on (e.g., disposed directly thereon) the second planarization insulating layer 123. The bank layer 125 may prevent an arc or the like from being generated at an edge of the sub-pixel electrode 210 by increasing a distance between the edge of the sub-pixel electrode 210 and the opposite electrode 230 above the sub-pixel electrode 210.

In an embodiment, the bank layer 125 may be formed of one or more organic insulating materials selected from a group consisting of polyimide, polyamide, an acrylic resin, BCB, and a phenol resin by a spin coating method or the like.

In an embodiment, the bank layer 125 may expose a portion of an upper surface of the sub-pixel electrode 210 to form an opening OP. For example, in an embodiment the bank layer 125 may directly contact lateral edges of the sub-pixel electrode 210 and may expose a central portion of the sub-pixel electrode 210 to form the opening OP. The intermediate layer 220 of the organic light-emitting diode OLED may be arranged in the opening OP formed by the bank layer 125. An emission area of the organic light-emitting diode OLED may be defined by the opening OP.

In an embodiment, the intermediate layer 220 may include an organic emission layer. The organic emission layer may include an organic material including a fluorescent material or a phosphorescent material emitting red, green, blue, or white light. The organic emission layer may include a low-molecular weight organic material or a polymer organic material, and a functional layer such as a hole transport layer (HTL), a hole injection layer (HIL), an electron transport layer (ETL), an electron injection layer (EIL), etc. may be further selectively disposed above or below the organic emission layer.

The organic emission layer may be arranged to correspond to each of sub-pixel electrodes 210 provided for each sub-pixel P. The intermediate layer 220 may be variously changed such as including a single-body layer over a plurality of sub-pixel electrodes 210, in addition to the organic emission layer.

The opposite electrode 230 may be a transparent electrode or a reflective electrode. In some embodiments, the opposite electrode 230 may be a transparent or a semi-transparent electrode, and may include a metal thin film having a low work function and including lithium (Li), calcium (Ca), lithium-fluoride-calcium (LiF/Ca), lithium-fluoride-aluminum (LiF/AI), Al, Ag, Mg, and a compound thereof. In addition, a transparent conductive oxide (TCO) film, such as ITO, IZO, ZnO, or In₂O₃, may be further disposed on the metal thin film. In an embodiment, the opposite electrode 230 may be integrally formed over an entire surface of the display area DA and may be disposed on the intermediate layer 220 and the bank layer 125. However, embodiments of the present invention are not necessarily limited thereto.

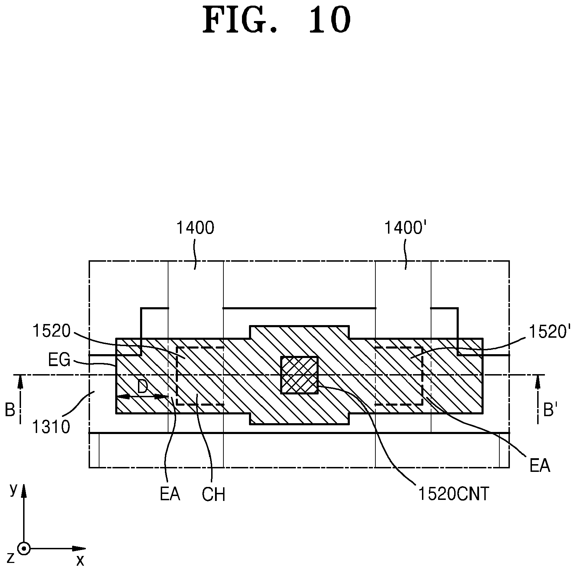

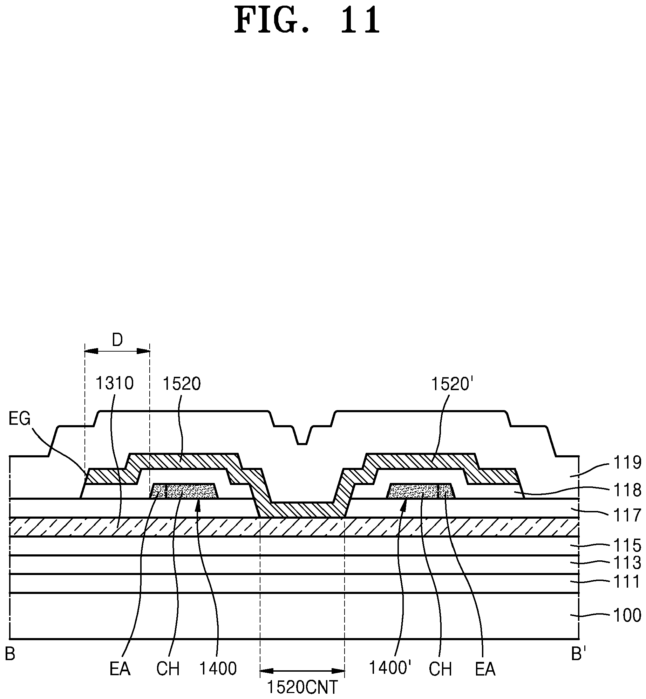

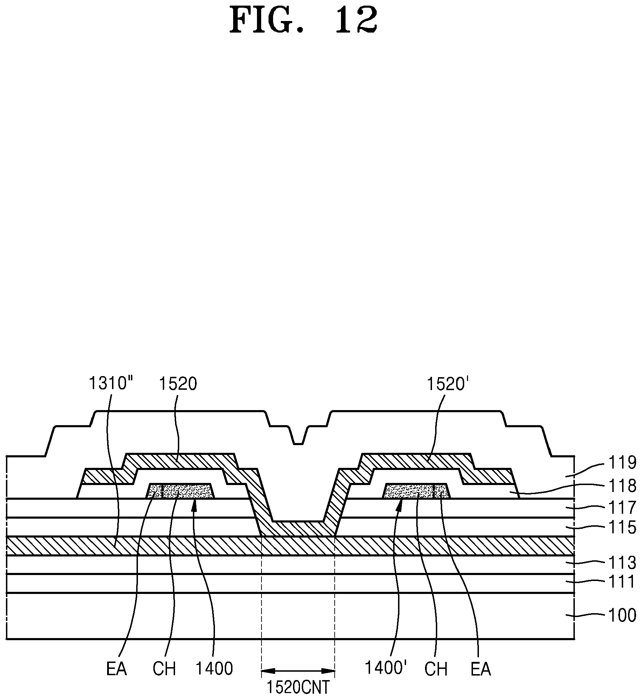

FIG. 10 is a schematic plan view illustrating a portion of a sub-pixel circuit according to an embodiment. FIG. 11 is a schematic cross-sectional view of the sub-pixel circuit of FIG. 10, taken along a line B-B'. FIG. 12 is a cross-sectional view illustrating a modified example of FIG. 11.

In FIGS. 10 and 11, the second active pattern 1400 and the fourth active pattern 1400', which are integrally formed, are referred to as the second active pattern 1400. In addition, the second gate electrode 1520 and the fourth gate electrode 1520', which are integrally formed, are referred to as the second gate electrode 1520. A conductive pattern forming the second gate electrode 1520 and the fourth gate electrode 1520' may be referred to as a 'gate pattern'. In an embodiment, the gate pattern may be arranged in an island shape. For example, the gate pattern may have a shape isolated from all other patterns disposed on the same layer. In an embodiment, the gate pattern may have a shape extending in a first direction (e.g., an x direction).

In an embodiment, the second gate electrode 1520 and the third gate line 1310 may be disposed above and below the second active pattern 1400, respectively (e.g., in the z direction). A portion of the second gate electrode 1520 and the third gate line 1310 may overlap the second active pattern 1400 (e.g., in the z direction) to form the first initialization thin-film transistor T4. In an embodiment, the second gate electrode 1520 and the third gate line 1310 may be electrically connected to each other through the contact hole 1520CNT for gate-sync. In an embodiment, the contact hole 1520CNT may be positioned at a central portion of the second gate electrode 1520 (e.g., a gate pattern).

However, embodiments of the present invention are not necessarily limited thereto. For example, in an embodiment as shown in FIG. 12, the second gate electrode 1520 and a third gate line 1310" may be respectively disposed above and below the second active pattern 1400 (e.g., in the z direction) configuring the first initialization thin-film transistor T4. In an embodiment, the third gate line 1310" may be included in the second conductive pattern 1200 and may be disposed on (e.g., disposed directly thereon) the first gate insulating layer 113. The third gate line 1310" may be disposed on the same layer as the first gate line 1210, the first gate electrode 1220, and the second gate line 1230 included in the second conductive pattern 1200, and may be arranged to be spaced apart from the first gate line 1210, the first gate electrode 1220, and the second gate line 1230. The third gate line 1310" may be electrically connected to the second gate electrode 1520 through the contact hole 1520CNT. The contact hole 1520CNT may be formed to penetrate the insulating layers (e.g., the second gate insulating layer 115, the first interlayer insulating layer 117, and the third gate insulating layer 118) between the third gate line 1310" and the second gate electrode 1520.

Hereinafter, an embodiment in which the third gate line 1310 is included in the third conductive pattern 1300 arranged between the first gate electrode 1220 and the second active pattern 1400 is described. However, a dummy pattern of the peripheral area PA to be described below may be applied to an embodiment in which the third gate line 1310" is included in the second conductive pattern 1200, which is the same layer as the first gate electrode 1220.

In an embodiment, the second active pattern 1400 configuring the first initialization thin-film transistor T4 may include an oxide semiconductor. When hydrogen or the like generated during a process of manufacturing a display apparatus or introduced from the outside is absorbed into an oxide semiconductor, the hydrogen or the like may function as a carrier. A portion of the second active pattern 1400, into which hydrogen or the like is absorbed, may be converted into a conductor.

Referring to FIGS. 10 and 11, in the second active pattern 1400, a portion overlapping (e.g., in the z direction) the second gate electrode 1520 may correspond to a channel area CH of the first initialization thin-film transistor T4, and other portions that are exposed by not overlapping (e.g., in the z direction) the second gate electrode 1520 may correspond to a source area and a drain area of the first initialization thin-film transistor T4.

Since the second gate electrode 1520 (e.g., a gate pattern) has an island shape, an edge EG of the second gate electrode 1520 may be relatively close to the channel area CH of the first initialization thin-film transistor T4. As a distance D (e.g., a distance in the x direction) between the edge EG of the second gate electrode 1520 and the channel area CH of the first initialization thin-film transistor T4 decreases, hydrogen diffusion from the edge EG of the second gate electrode 1520 to the channel area CH of the first initialization thin-film transistor T4 may be relatively easy. For example, when hydrogen introduced from the outside reaches the second gate electrode 1520, an area EA adjacent to the edge EG of the second gate electrode 1520 may be easily exposed to hydrogen from among a portion of the second active pattern 1400, which overlaps the second gate electrode 1520. When the adjacent area EA is converted to a conductor, the channel area CH of the first initialization thin-film transistor T4 may be reduced. Accordingly, characteristics of the first initialization thin-film transistor T4 may be changed.

In particular, hydrogen introduced from the outside through the peripheral area PA adjacent thereto may easily reach a sub-pixel arranged closed to the edge of the display area DA, for example, the second edge E2 (refer to FIG. 3) of the display area DA. Accordingly, there may be further concern about changes in the characteristics of the first initialization thin-film transistor T4 having the second gate electrode 1520 in an island shape.

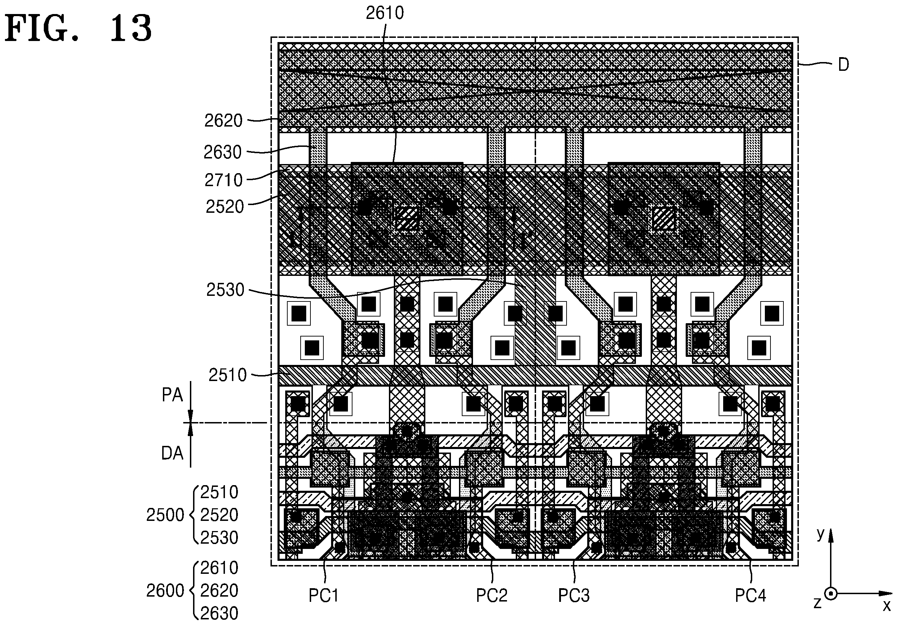

However, in a display apparatus according to an embodiment, such a change in characteristics of the first initialization thin-film transistor T4 may be prevented by arranging a dummy pattern in the peripheral area PA. Hereinafter, a dummy pattern is described in more detail with reference to FIGS. 13 to 18.

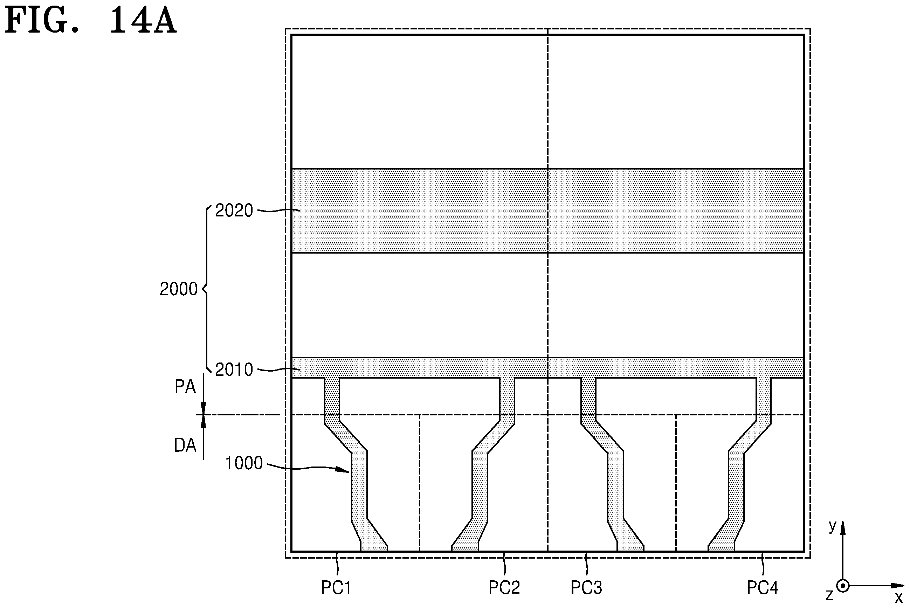

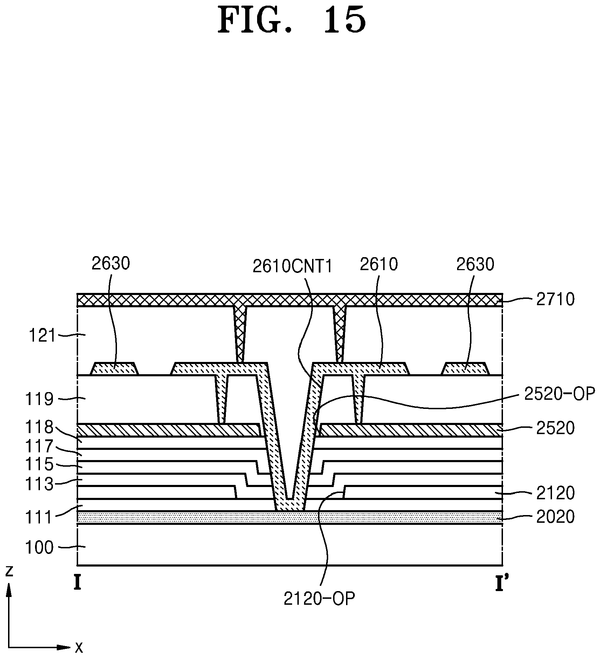

FIG. 13 is a schematic enlarged plan view of a portion of a display apparatus according to an embodiment of the present invention, and FIGS. 14A to 14E are plan views illustrating a structure of FIG. 13 for each layer. FIG. 15 is a schematic cross-sectional view of the display apparatus of FIG. 13, taken along a line I-I'.

FIG. 13 shows a portion of a sub-pixel circuit included in sub-pixels arranged at an outer portion of the display area DA and the first peripheral voltage line 2020, the second peripheral voltage line 2620, and a dummy pattern 2500 arranged in the peripheral area PA.

In an embodiment, the display apparatus may include the first sub-pixel P1, the second sub-pixel P2, a third sub-pixel P3, and a fourth sub-pixel P4, which are arranged adjacent to the second edge E2 (refer to FIG. 3) of the display area DA. In an embodiment, the third sub-pixel P3 and the fourth sub-pixel P4 may have a structure in which the same sub-pixel structure as the first sub-pixel P1 and the second sub-pixel P2 is repeated. In an embodiment, the first sub-pixel P1 may include the first sub-pixel circuit PC1, and the second sub-pixel P2 may include the second sub-pixel circuit PC2. The third sub-pixel P3 may include a third sub-pixel circuit PC3, and the fourth sub-pixel P4 may include a fourth sub-pixel circuit PC4. The first sub-pixel circuit PC1 may correspond to the first sub-pixel circuit PC1 described above with reference to FIGS. 7 to 9.

Referring to FIGS. 13, 14A, and 15, in the peripheral area PA, a first peripheral conductive pattern 2000 may be disposed on (e.g., disposed directly thereon) the substrate 100. In an embodiment, the first peripheral conductive pattern 2000 may include a first peripheral line 2010 and a first peripheral voltage line 2020.

The first peripheral line 2010 may extend in a first direction (e.g., an x direction). The first peripheral line 2010 may be connected to (e.g., directly connected thereto) portions extending from the first conductive pattern 1000 in the display area DA.

In an embodiment, the first peripheral voltage line 2020 may extend in the first direction (e.g., the x direction). The first peripheral voltage line 2020 may be spaced apart from the first peripheral line 2010 in a plan view (e.g., in the y direction).

The first peripheral conductive pattern 2000 may be disposed on the same layer as the first conductive pattern 1000 described above with reference to FIG. 8A. In an embodiment, the first peripheral conductive pattern 2000 may include the same material as the first conductive pattern 1000 and may be formed in the same process as the first conductive pattern 1000.

The buffer layer 111 may be disposed on (e.g., disposed directly thereon) the first peripheral line 2010 and the first peripheral voltage line 2020 of the first peripheral conductive pattern 2000.

Referring to FIGS. 13, 14B, and 15, a peripheral active pattern 2100 may be disposed on (e.g., disposed directly thereon) the buffer layer 111 in the peripheral area PA. In an embodiment, the peripheral active pattern 2100 may include first sub-active patterns 2110 and a second sub-active pattern 2120.

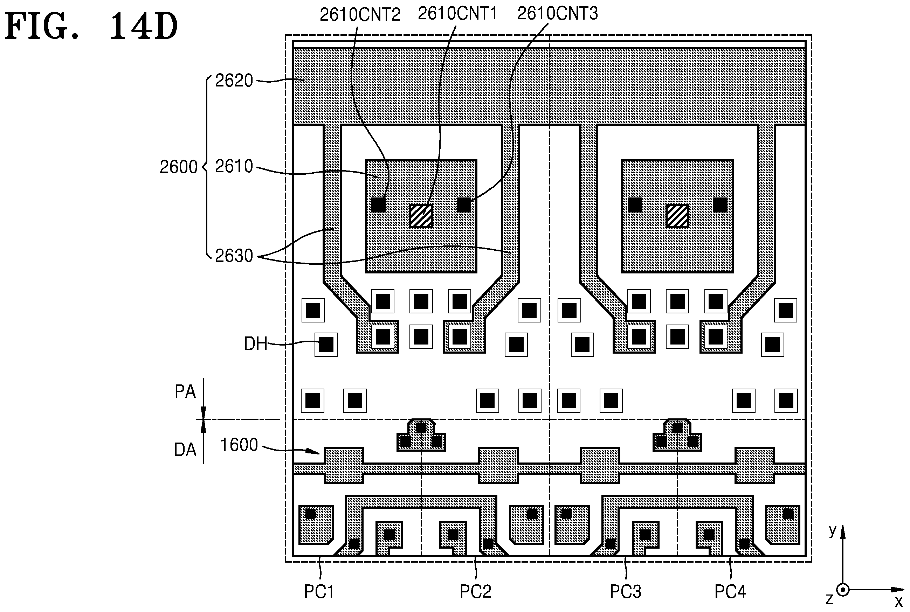

A plurality of first sub-active patterns 2110 may be provided. The first sub-active patterns 2110 may be spaced apart from the second sub-active pattern 2120 in a plan view (e.g., in the y direction). In an embodiment, the first sub-active patterns 2110 may each be arranged in an island shape. The first sub-active patterns 2110 may be spaced apart from each other in a plan view. The first sub-active patterns 2110 may respectively overlap dummy holes DH of FIG. 14D to be described below (e.g., in the z direction). The first sub-active patterns 2110 may prevent moisture or foreign materials from entering from the substrate 100 through the dummy holes DH.

In an embodiment, the second sub-active pattern 2120 may extend in a first direction (e.g., an x direction). The second sub-active pattern 2120 may overlap the first peripheral voltage line 2020 in a plan view (e.g., in the z direction). In an embodiment, the second sub-active pattern 2120 may include an opening 2120-OP exposing the first peripheral voltage line 2020.

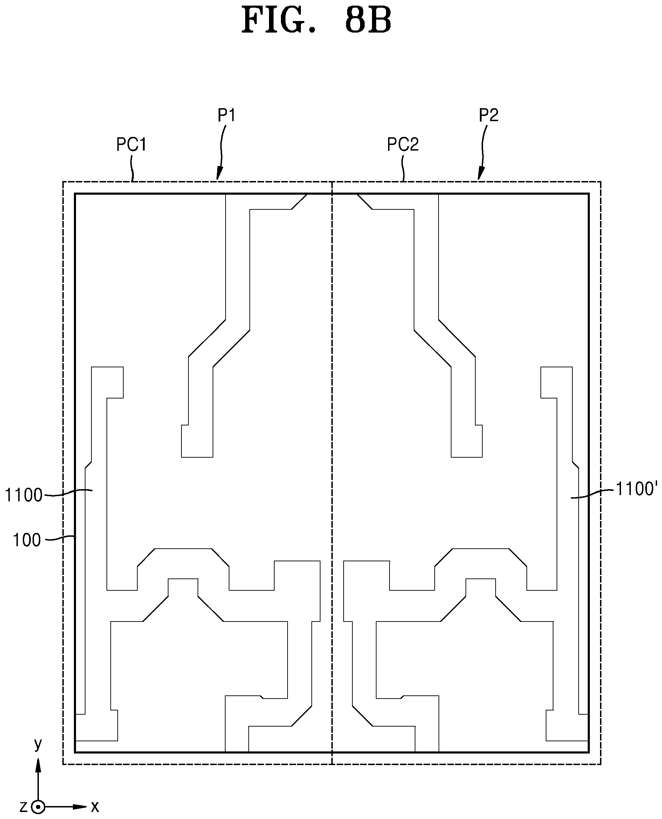

The peripheral active pattern 2100 may be disposed on the same layer as the first active pattern 1100 described above with reference to FIG. 8B. In an embodiment, the peripheral active pattern 2100 may include the same material as the first active pattern 1100 and may be formed in the same process as the first active pattern 1100.

The first gate insulating layer 113, the second gate insulating layer 115, the first interlayer insulating layer 117, and the third gate insulating layer 118 may be sequentially arranged on the peripheral active pattern 2100 (e.g., in the z direction).

Referring to FIGS. 13, 14C, and 15, a dummy pattern 2500 may be disposed on (e.g., disposed directly thereon) the third gate insulating layer 118 in the peripheral area PA. In an embodiment, the dummy pattern 2500 may include a first dummy pattern 2510, a second dummy pattern 2520, and a connection portion 2530.

In an embodiment, the first dummy pattern 2510 may extend in the first direction (e.g., the x direction). The first dummy pattern 2510 may surround at least a portion of the display area DA in a plan view. For example, in an embodiment the first dummy pattern 2510 may be arranged along the second edge E2 (refer to FIG. 3) of the display area DA. The first dummy pattern 2510 may be arranged between the first peripheral voltage line 2020 and the display area in a plan view (e.g., in the y direction) and between a third peripheral voltage line 2710 and the display area DA in a plan view (e.g., in the y direction). The first dummy pattern 2510 may also be arranged between a second peripheral voltage line 2620 and the display area DA in a plan view.

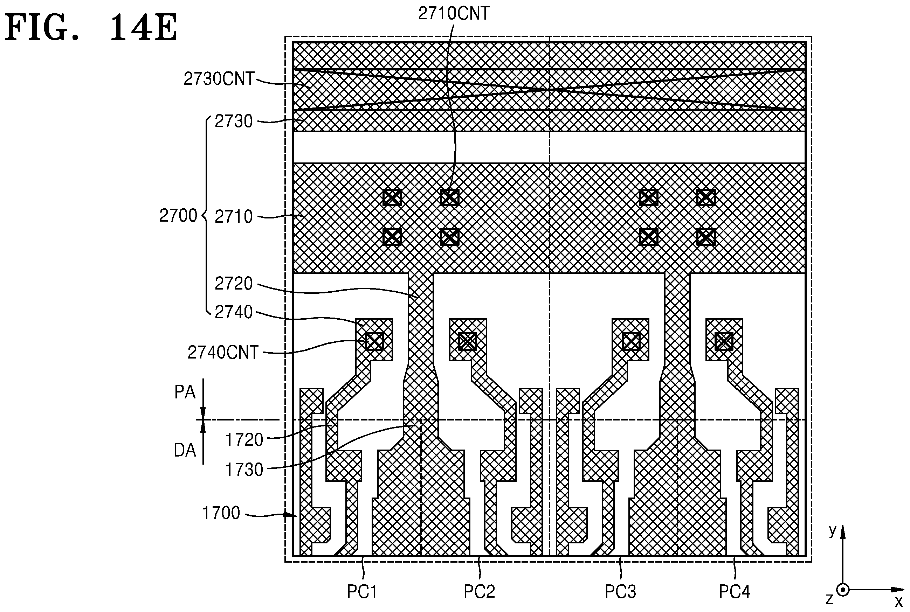

In an embodiment, the second dummy pattern 2520 may extend in the first direction (e.g., the x direction). The second dummy pattern 2520 may be spaced apart from the first dummy pattern 2510 in a plan view (e.g., in the y direction). The second dummy pattern 2520 may overlap (e.g., in the z direction) the first peripheral voltage line 2020, a peripheral transmission pattern 2610 of FIG. 14D, and the third peripheral voltage line 2710 of FIG. 14E. In an embodiment, the second dummy pattern 2520 may receive the driving voltage ELVDD through the peripheral transmission pattern 2610. The second dummy pattern 2520 may include an opening 2520-OP. The opening 2520-OP of the second dummy pattern 2520 may overlap (e.g., in the z direction) the opening 2120-OP of the second sub-active pattern 2120. The opening 2520-OP of the second dummy pattern 2520 may expose the first peripheral voltage line 2020 overlapping the opening 2120-OP of the second sub-active pattern 2120.

In an embodiment, the connection portion 2530 may extend in the second direction (e.g., the y direction). The connection portion 2530 may connect the first dummy pattern 2510 and the second dummy pattern 2520 to each other. In an embodiment, the first dummy pattern 2510, the second dummy pattern 2520, and the connection portion 2530 may be integrally provided.

The dummy pattern 2500 may be disposed on the same layer as the fourth conductive pattern 1500 described above with reference to FIG. 8F. In an embodiment, the dummy pattern 2500 may include the same material as the fourth conductive pattern 1500 and may be formed in the same process as the fourth conductive pattern 1500. For example, the dummy pattern 2500 may be disposed on the same layer as the second gate electrode 1520 configuring the first initialization thin-film transistor T4.

The display apparatus according to an embodiment may include the dummy pattern 2500 disposed on the same layer as the second gate electrode 1520. The dummy pattern 2500 may be arranged in the peripheral area PA and may reduce diffusion of hydrogen from the outside into the second gate electrode 1520 of the display area DA. Accordingly, a change in characteristics of the first initialization thin-film transistor T4 may be prevented. Also, the process distribution of the display apparatus may be increased, and a display apparatus with increased reliability may be provided.

The second interlayer insulating layer 119 may be disposed on (e.g., disposed directly thereon) the dummy pattern 2500.

Referring to FIGS. 13, 14D, and 15, a second peripheral conductive pattern 2600 may be disposed on the second interlayer insulating layer 119 in the peripheral area PA. In an embodiment, the second peripheral conductive pattern 2600 may include the peripheral transmission pattern 2610, the second peripheral voltage line 2620, and first extension portions 2630.

The peripheral transmission pattern 2610 may be arranged in an island shape. In an embodiment, the peripheral transmission pattern 2610 may be spaced apart from the second peripheral voltage line 2620 and the first extension portions 2630 in a plan view. The peripheral transmission pattern 2610 may be arranged between two adjacent first extension portions 2630 among the first extension portions 2630 (e.g., in the x direction). The peripheral transmission pattern 2610 may overlap the second sub-active pattern 2120 (e.g., in the z direction). The peripheral transmission pattern 2610 may overlap the second dummy pattern 2520 (e.g., in the z direction). In an embodiment, the peripheral transmission pattern 2610 may be in direct contact with the first peripheral voltage line 2020 through a contact hole 2610CNT1 overlapping the opening 2520-OP of the second dummy pattern 2520 and the opening 2120-OP of the second sub-active pattern 2120. The contact hole 2610CNT1 may penetrate the insulating layers (e.g., the buffer layer 111, the first gate insulating layer 113, the second gate insulating layer 115, the first interlayer insulating layer 117, the third gate insulating layer 118, and the second interlayer insulating layer 119 of FIG. 15) between the first peripheral voltage line 2020 and the peripheral transmission pattern 2610. The peripheral transmission pattern 2610 may transmit the driving voltage ELVDD to the first peripheral voltage line 2020. In an embodiment, the peripheral transmission pattern 2610 may be in direct contact with the second dummy pattern 2520 through contact holes 2610CNT2 and 2610CNT3. The peripheral transmission pattern 2610 may transmit the driving voltage ELVDD to the second dummy pattern 2520.

In an embodiment, the second peripheral voltage line 2620 may extend in the first direction (e.g., the x direction). The second peripheral voltage line 2620 may correspond to the second power supply line 16 of FIG. 3. The common voltage ELVSS may be provided through the second peripheral voltage line 2620.

The first extension portions 2630 may extend in the second direction (e.g., the y direction) towards the display area DA from the second peripheral voltage line 2620. The first extension portions 2630 may be integrally provided with the second peripheral voltage line 2620. The first extension portions 2630 may provide the common voltage ELVSS from the second peripheral voltage line 2620.

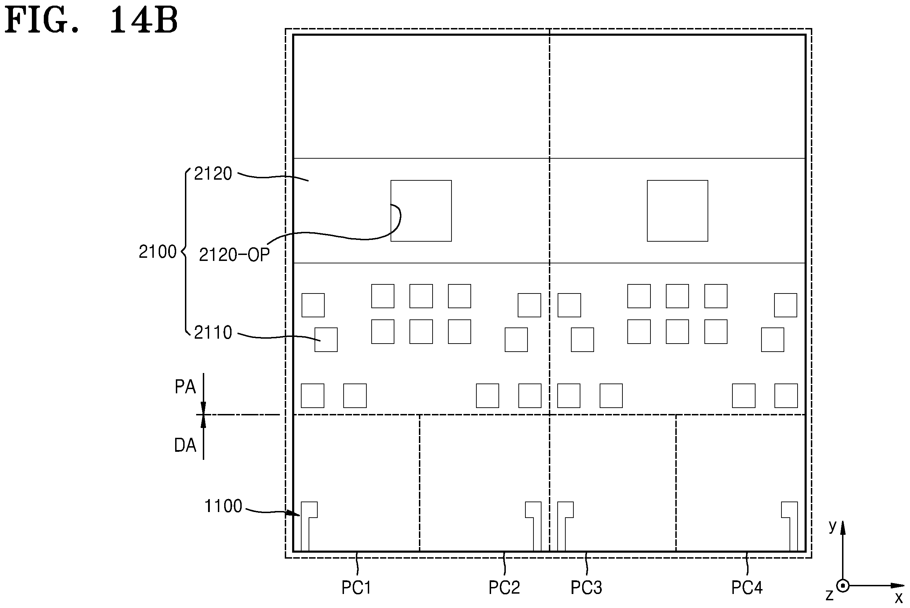

In an embodiment, the dummy holes DH may be formed in the same process as the contact holes 2610CNT1, 2610CNT2, and 2610CNT3 of the second peripheral conductive pattern 2600. The dummy holes DH may respectively overlap the second sub-active pattern 2120 of FIG. 14B (e.g., in the z direction). The dummy holes DH may be formed by penetrating the insulating layers (e.g., the first gate insulating layer 113, the second gate insulating layer 115, the first interlayer insulating layer 117, and the third gate insulating layer 118) on the second sub-active pattern 2120. In an embodiment, the dummy holes DH may outgas hydrogen, which may affect the characteristics of an oxide semiconductor, to the outside (e.g., the external environment).

The second peripheral conductive pattern 2600 may be disposed on the same layer as the fifth conductive pattern 1600 described above with reference to FIG. 8G. In an embodiment, the second peripheral conductive pattern 2600 may include the same material as the fifth conductive pattern 1600 and may be formed in the same process as the fifth conductive pattern 1600.

The first planarization insulating layer 121 may be disposed on (e.g., disposed directly thereon) the second peripheral conductive pattern 2600.

Referring to FIGS. 13, 14E, and 15, a third peripheral conductive pattern 2700 may be disposed on (e.g., disposed directly thereon) the first planarization insulating layer 121 in the peripheral area PA. In an embodiment, the third peripheral conductive pattern 2700 may include the third peripheral voltage line 2710, a second extension portion 2720, a fourth peripheral voltage line 2730, and a third extension portion 2740.

In an embodiment, the third peripheral voltage line 2710 may extend in the first direction (e.g., the x direction). The third peripheral voltage line 2710 may correspond to the first power supply line 15 (e.g., the first-3 power supply line 15-3) of FIG. 3. The driving voltage ELVDD may be provided through the third peripheral voltage line 2710. The third peripheral voltage line 2710 may overlap the first peripheral voltage line 2020 and the peripheral transmission pattern 2610 (e.g., in the z direction). In an embodiment, the third peripheral voltage line 2710 may be in direct contact with the peripheral transmission pattern 2610 through a contact hole 2710CNT. The third peripheral voltage line 2710 may transmit the driving voltage ELVDD to the second dummy pattern 2520 through the peripheral transmission pattern 2610. In addition, the third peripheral voltage line 2710 may transmit the driving voltage ELVDD to the first peripheral voltage line 2020 through the peripheral transmission pattern 2610. The third peripheral voltage line 2710 may overlap the second dummy pattern 2520 (e.g., in the z direction).

The second extension portion 2720 may extend in the second direction (e.g., the y direction) towards the display area DA from the third peripheral voltage line 2710. In an embodiment, the second extension portion 2720 may be integrally provided with the third peripheral voltage line 2710. The second extension portion 2720 may be connected to (e.g., directly connected thereto) the voltage line 1730 of the sixth conductive pattern 1700 in the display area DA. In an embodiment, the second extension portion 2720 may be integrally provided with the voltage line 1730. The second extension portion 2720 may transmit the driving voltage ELVDD received from the third peripheral voltage line 2710 to the voltage line 1730 in the display area DA.

In an embodiment, the fourth peripheral voltage line 2730 may extend in the first direction (e.g., the x direction). The fourth peripheral voltage line 2730 may be spaced apart from the third peripheral voltage line 2710 and the second extension portion 2720 in a plan view (e.g., in the y direction). The fourth peripheral voltage line 2730 may overlap the second peripheral voltage line 2620 (e.g., in the z direction). In an embodiment, the fourth peripheral voltage line 2730 may be in direct contact with the second peripheral voltage line 2620 through a contact hole 2730CNT. The common voltage ELVSS may be provided to the fourth peripheral voltage line 2730.

Third extension portions 2740 may extend from the second connection line 1720 of the sixth conductive pattern 1700 in the display area DA. The third extension portions 2740 may be integrally provided with the second connection lines 1720. The third extension portions 2740 may respectively be connected to the first extension portions 2630 of FIG. 14D through a contact hole 2740CNT. The third extension portions 2740 may transmit the common voltage ELVSS received from the first extension portions 2630 to the second connection line 1720.

Referring to FIG. 15, the second dummy pattern 2520 may overlap at least some of the first extension portions 2630 (e.g., in the z direction). For example, in an embodiment one insulating layer (e.g., the second interlayer insulating layer 119 of FIG. 15) may be between the second dummy pattern 2520 and the first extension portions 2630 (e.g., in the z direction). As described above, the driving voltage ELVDD may be provided to the second dummy pattern 2520, and the common voltage ELVSS may be provided to the first extension portions 2630.

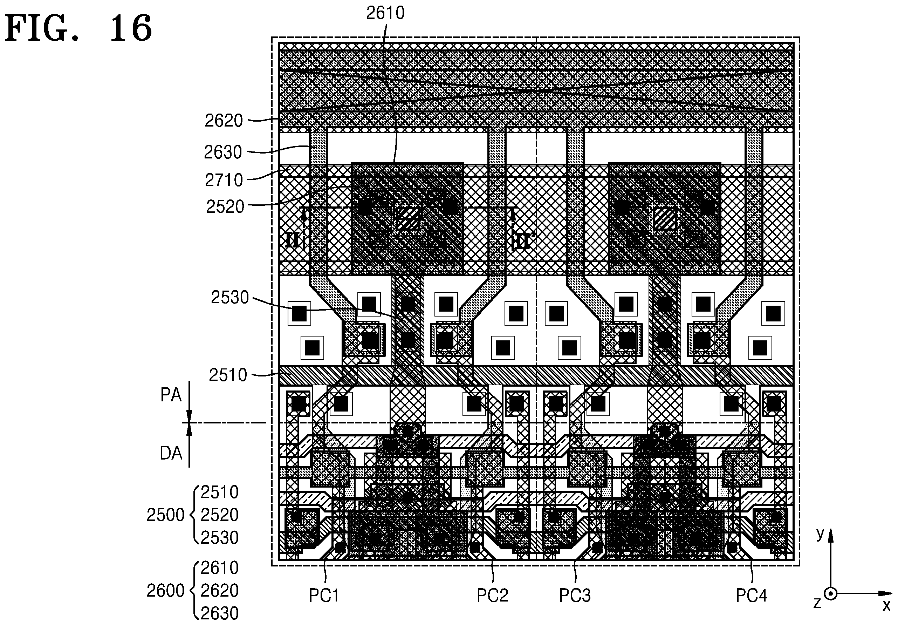

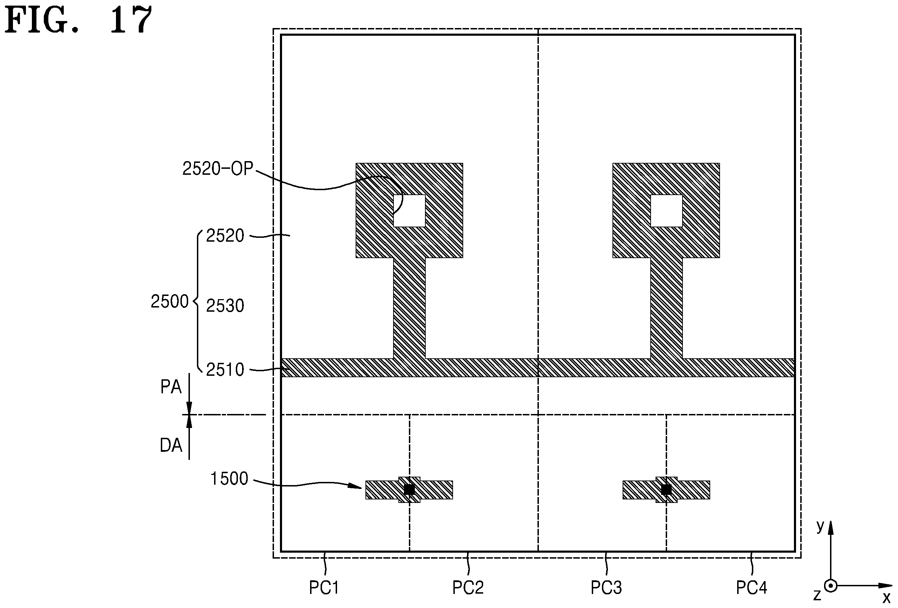

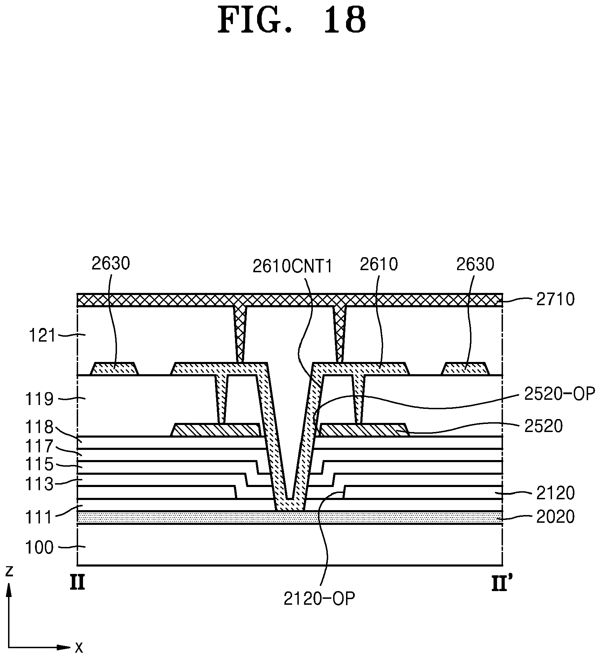

FIG. 16 is a schematic enlarged plan view of a portion of a display apparatus of the invention. FIG. 17 is a plan view illustrating some layers of FIG. 16 and shows extracts of a dummy pattern and patterns disposed on the same layer as the dummy pattern. FIG. 18 is a schematic cross-sectional view of the display apparatus of FIG. 16, taken along a line II-II'. FIGS. 16 to 18 are modified examples of FIGS. 13 to 15, which have differences in a structure of a dummy pattern. Hereinafter, the differences are mainly described and redundant descriptions may be omitted for economy of description.

Referring to FIGS. 16, 17, and 18, the dummy pattern 2500 may be arranged in the peripheral area PA. In an embodiment, the dummy pattern 2500 may include the first dummy pattern 2510, the second dummy pattern 2520, and the connection portion 2530.

The first dummy pattern 2510 may extend in the first direction (e.g., the x direction). In an embodiment, the second dummy patterns 2520 may each have an island shape. The second dummy patterns 2520 may be arranged to be spaced apart from each other in the first direction (e.g., the x direction). The second dummy pattern 2520 may be spaced apart from the first dummy pattern 2510 in a plan view. The connection portions 2530 may extend in the second direction (e.g., the y direction). The connection portions 2530 may respectively connect the second dummy patterns 2520 to the first dummy pattern 2510.

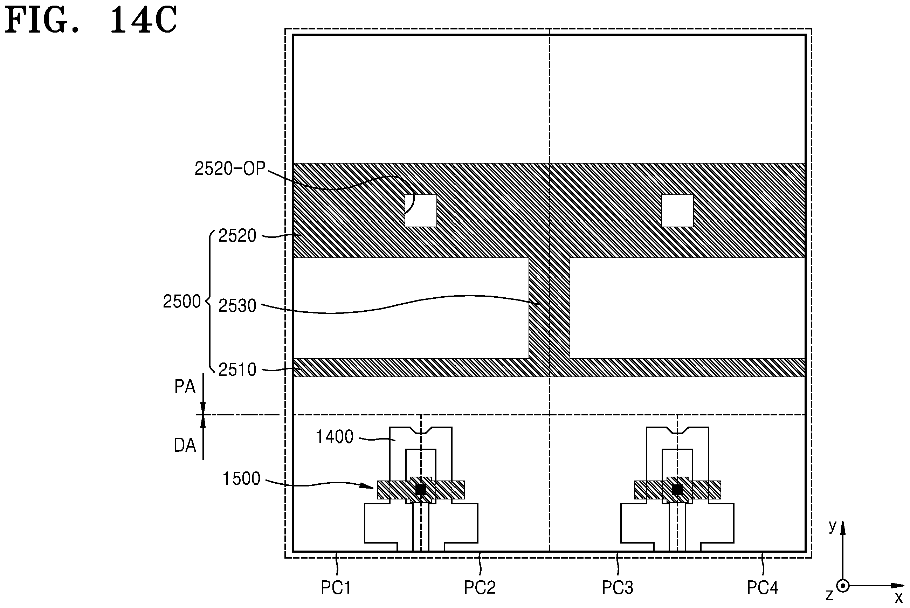

The second dummy patterns 2520 may be spaced apart from the first extension portions 2630 in a plan view (e.g., in the x direction). The second dummy patterns 2520 may not overlap the first extension portions 2630 (e.g., in the z direction) and may be electrically insulated therefrom. As shown in FIGS. 14 and 15, in an embodiment in which the second dummy pattern 2520 and the first extension portions 2630 overlap each other, a short and/or burnt phenomenon may occur between the second dummy pattern 2520 and the first extension portions 2630 due to an external impact or impurities introduced during a manufacturing process. However, in an embodiment as shown in FIG. 18, the second dummy pattern 2520 is spaced apart from the first extension portions 2630 without overlapping the first extension portions 2630 (e.g., in the z direction), and thus the probability of such a short and/or burnt phenomenon occurring may be reduced. Also, a change in characteristics of the first initialization thin-film transistor T4 may be prevented by including the dummy pattern 2500 disposed on the same layer as the second gate electrode 1520.

As a display apparatus according to an embodiment includes a dummy pattern arranged in a peripheral area, a display apparatus with increased device characteristics and reduced defect occurrence of a thin-film transistor may be provided. However, the scope of embodiments of the present invention is not limited by these effects.

It should be understood that embodiments described herein should be considered in a descriptive sense only and not for purposes of limitation. Descriptions of features or aspects within each embodiment should typically be considered as available for other similar features or aspects in other embodiments. While one or more embodiments have been described with reference to the figures, it will be understood by those of ordinary skill in the art that various changes in form and details may be made therein without departing from the scope of the present claims.

## Claims

1. A display apparatus comprising:
a substrate (100) comprising a display area (DA) and a peripheral area (PA) outside the display area (DA);
a first active pattern (1100) arranged in the display area (DA);
a first gate electrode (1220) disposed on the first active pattern (1100);
a second active pattern (1400) disposed on the first gate electrode (1220);
a second gate electrode (1520) disposed on the second active pattern (1400); and
a dummy pattern (2500) arranged in the peripheral area (PA), the dummy pattern (2500) extending in a first direction,
wherein the dummy pattern (2500) is disposed on a same layer as the second gate electrode (1520).

2. The display apparatus of claim 1, wherein:
the second gate electrode (1520) extends in the first direction;
the second active pattern (1400) extends in a second direction crossing the first direction; and
the second active pattern (1400) at least partially overlaps the second gate electrode (1520) in a plan view.

3. The display apparatus of claim 1 or 2, further comprising a gate line (1310) extending in the first direction,
wherein the second gate electrode (1520) is electrically connected to the gate line (1310) through a contact hole (1520CNT) penetrating an insulating layer (117, 118) between the second gate electrode (1520) and the gate line (1310).

4. The display apparatus of claim 3, wherein the gate line (1310) is disposed between the first gate electrode (1220) and the second active pattern (1400).

5. The display apparatus of at least one of claims 1 to 4, further comprising:
a first sub-pixel (P1) comprising a first sub-pixel circuit (PC1) and a second sub-pixel (P2) comprising a second sub-pixel circuit (PC2), the first sub-pixel (P1) and the second sub-pixel (P2) are arranged in the display area (DA) to be adjacent to each other,
wherein the first sub-pixel circuit (PC1) comprises the first active pattern (1100), the first gate electrode (1220), the second active pattern (1400), and the second gate electrode (1520), and
the first sub-pixel circuit (PC1) and the second sub-pixel circuit (PC2) have symmetrical shapes to each other based on a virtual line between the first sub-pixel circuit (PC1) and the second sub-pixel circuit (PC2).

6. The display apparatus of claim 5, wherein the second sub-pixel circuit (PC2) comprises:
a third active pattern (1100') on the substrate (100);
a third gate electrode (1220') disposed on the third active pattern (1100');
a fourth active pattern (1400') disposed on the third gate electrode (1220'); and
a fourth gate electrode (1520') disposed on the fourth active pattern (1400'),
wherein the second gate electrode (1520) and the fourth gate electrode (1520') are integral to each other and comprise one gate pattern.

7. The display apparatus of claim 6, wherein, in a plan view, the gate pattern has a shape isolated from all other patterns disposed on a same layer as the gate pattern.

8. The display apparatus of claim 5 or 6, wherein:
each of the first active pattern (1100) and the third active pattern (1100') comprises a silicon semiconductor material; and
each of the second active pattern (1400) and the fourth active pattern (1400') comprises an oxide semiconductor material.

9. The display apparatus of at least one of claims 1 to 8, further comprising:
a first peripheral voltage line (2020) arranged in the peripheral area (PA) and extending in the first direction; and
a second peripheral voltage line (2620) arranged outside the first peripheral voltage line (2020) and extending in the first direction.

10. The display apparatus of claim 9, wherein the dummy pattern (2500) is electrically connected to the first peripheral voltage line (2020).

11. The display apparatus of claim 9 or 10, further comprising extension portions (2630) extending from the second peripheral voltage line (2620) in a second direction perpendicular to the first direction.

12. The display apparatus of claim 11, wherein the dummy pattern (2500) is electrically insulated from the second peripheral voltage line (2620) and the extension portions (2630).

13. The display apparatus of claim 11 or 12, wherein, in a plan view, the dummy pattern (2500) overlaps the extension portions (2630) in a plan view.

14. The display apparatus of at least one of claims 1 to 13, wherein the dummy pattern (2500) comprises:
a first dummy pattern (2510) extending in the first direction;
a second dummy pattern (2520) spaced apart from the first dummy pattern (2510) and extending in the first direction; and
a connection portion (2530) connecting the first dummy pattern (2510) to the second dummy pattern (2520),
wherein the first dummy pattern (2510), the second dummy pattern (2520), and the connection portion (2530) are integral to each other.

15. The display apparatus of claim 14 and at least one of claims 9 to 13, wherein, in a plan view, the first dummy pattern (2510) is arranged between the display area (DA) and the first peripheral voltage line (2020).

16. The display apparatus of claim 14 or 15 and at least one of claims 9 to 13, wherein, in a plan view, the second dummy pattern (2520) overlaps the first peripheral voltage line (2020).

17. The display apparatus of at least one of claims 14 to 16 and at least one of claims 9 to 13, wherein, in a plan view, the second dummy pattern (2520) overlaps at least some of the extension portions (2630).

18. The display apparatus of claim 11 or 12, wherein, in a plan view, the dummy pattern (2500) is spaced apart from the extension portions (2630) and does not overlap the extension portions (2630).

19. The display apparatus of claim 18, wherein the dummy pattern (2500) comprises:
a first dummy pattern (2510) extending in the first direction;
second dummy patterns (2520) spaced apart from each other in the first direction; and
connection portions (2530) respectively connecting the second dummy patterns (2520) to the first dummy pattern (2510),
wherein the first dummy pattern (2510), the second dummy patterns (2520), and the connection portions (2530) are integral to each other.

20. The display apparatus of claim 19, wherein, in a plan view, each of the second dummy patterns (2520) is arranged between two adjacent extension portions (2630).
